# EUROPÄISCHE PATENTSCHRIFT

(11) **EP 3 666 050 B1**
(45) Veröffentlichungstag und Bekanntmachung des Hinweises auf die Patenterteilung: **01.09.2021**
(21) Anmeldenummer: 19206116.6
(22) Anmeldetag: 30.10.2019
(51) Int. Cl.: A01B 69/04, A01B 79/00

(54) **LANDWIRTSCHAFTLICHES ARBEITSSYSTEM**
AGRICULTURAL SYSTEM
SYSTÈME DE TRAVAIL AGRICOLE

(30) Priorität: 13.12.2018 DE 102018132144
(43) Veröffentlichungstag der Anmeldung: 17.06.2020
(73) Patentinhaber: CLAAS E-Systems GmbH, 49201 Dissen (DE)
(72) Erfinder: Meyer zu Helligen, Lars Peter, 32139 Spenge (DE)
(74) Vertreter: CLAAS Gruppe

(56) Entgegenhaltungen:
- EP-A1- 3 219 184
- EP-B1- 1 619 517
- DE-A1- 4 322 293
- DE-A1-102004 043 169

## Beschreibung

Die Erfindung betrifft ein landwirtschaftliches Arbeitssystem nach dem Oberbegriff des Anspruchs 1 sowie ein Verfahren zur Optimierung von landwirtschaftlichen Arbeitsabläufen unter Verwendung eines landwirtschaftlichen Arbeitssystems nach dem Oberbegriff des Anspruchs 16.

Das landwirtschaftliche Arbeitssystem (EP 1 619 517 B1), von dem die Erfindung ausgeht, weist mehrere landwirtschaftliche Arbeitseinheiten auf, die in bestimmten Arbeitssituationen miteinander zusammenarbeiten. Bei den landwirtschaftlichen Arbeitseinheiten handelt es sich um landwirtschaftliche Arbeitsmaschinen und Anbaugeräte, also mobile landwirtschaftliche Einrichtungen, und/oder um stationäre landwirtschaftliche Einrichtungen. Bei einer landwirtschaftlichen Arbeitsmaschine kann es sich um jedwede landwirtschaftliche Arbeitsmaschine handeln, die der Abarbeitung eines landwirtschaftlichen Arbeitsauftrags, beispielsweise einer Bodenbearbeitung wie Pflügen, Grubbern, Eggen oder dergleichen dient. Dazu gehören Zugmaschinen, insbesondere Traktoren, grundsätzlich aber auch Erntemaschinen, insbesondere Mähdrescher, Feldhäcksler oder dergleichen. Eine solche landwirtschaftliche Arbeitsmaschine verfügt über mindestens ein Arbeitsaggregat wie einen Schrägförderer, ein Dreschwerk, eine Häckseleinrichtung, einen Fahrantrieb, ein Lenksystem oder dergleichen. Landwirtschaftliche Arbeitsmaschinen, insbesondere in Form von Zugmaschinen wie Traktoren, können auch mit einem Anbaugerät gekoppelt sein, das in diesem Zusammenhang ebenfalls eine landwirtschaftliche Arbeitseinheit bildet. Bei einem Anbaugerät handelt es sich beispielsweise um einen Pflug, einen Grubber, eine Egge, ein Mähwerk, eine Ballenpresse oder dergleichen. Auch solche Anbaugeräte weisen mindestens ein Arbeitsaggregat auf, eine Ballenpresse beispielsweise eine Erntegutaufnahmeeinrichtung, eine Erntegutpresseinrichtung etc. Landwirtschaftliche Arbeitseinheiten in Form einer stationären landwirtschaftlichen Einrichtung sind beispielsweise Getreidetrocknungseinrichtungen, Getreidelager oder dergleichen. Solche stationären Einrichtungen verfügen ebenfalls über mindestens ein Arbeitsaggregat, eine Getreidetrocknungseinrichtung beispielsweise über eine Getreidezuführ- und/oder Transporteinrichtung, eine Heizeinrichtung etc.

Bei dem bekannten landwirtschaftlichen Arbeitssystem stellen die einzelnen landwirtschaftlichen Arbeitseinheiten jeweils als Ganzes eine Funktionseinheit zur Durchführung oder Unterstützung landwirtschaftlicher Arbeit dar. Jede der Funktionseinheiten weist eine eigene Steuerungseinrichtung zur Steuerung der jeweiligen Funktionseinheit auf. Die Steuerung erfolgt dabei basierend auf einem hinterlegten Regelwerk. Die einzelnen Funktionseinheiten verfügen ferner über eine eigene Kommunikationsschnittstelle, über die ein Datenaustausch zwischen denjenigen Funktionseinheiten möglich ist, die in einer bestimmten Arbeitssituation zusammenarbeiten. Der Datenaustausch erfolgt dabei automatisch ohne Eingriff durch den Bediener. Dabei tauschen die einzelnen Funktionseinheiten untereinander beispielsweise Teilnehmeridentifikationen, geografische Positionsdaten, Zeitfenster, Fahrgeschwindigkeiten, Fahrtrichtungsinformationen, spezifische Parameter des jeweils durchgeführten Arbeitsablaufs oder dergleichen aus, um dadurch das Zusammenarbeiten der Funktionseinheiten zu koordinieren. Beispielsweise kann ein Überladevorgang koordiniert werden, bei dem ein Mähdrescher, der eine Funktionseinheit bildet, Korn aus seinem Korntank in einen Aufnahmebehäter eines Abtankfahrzeugs, beispielsweise in einen mit einer weiteren landwirtschaftlichen Arbeitsmaschine gekoppelten Transportanhänger, überlädt, wobei das Abtankfahrzeug bzw. die Einheit aus weiterer landwirtschaftlicher Arbeitsmaschine und Transportanhänger eine weitere Funktionseinheit bildet.

Weitere landwirtschaftliche Arbeitssysteme sind aus den Druckschriften DE 43 22 293 A1, DE 10 2004 043169 A1 und EP 3 219 184 A1 bekannt.

Aufgrund der vielfältigen Varianten der Zusammenarbeit von landwirtschaftlichen Arbeitseinheiten im Zusammenhang mit einer Vielzahl an unterschiedlichen Anbaugeräten in Kombination mit weitestgehend unbekannten Umweltbedingungen kann mit dem bekannten landwirtschaftlichen Arbeitssystem nicht immer ein befriedigendes Ergebnis der Optimierung von landwirtschaftlichen Arbeitsabläufen erzielt werden. Dies gilt nicht nur für Ernteprozesse, sondern besonders beim Einsatz von Traktoren mit Anbaugeräten, da hier eine besonders große Variation von Zugmaschine, Anbaugerät, Art der Tätigkeit möglich ist.

Der Erfindung liegt das Problem zugrunde, das bekannte landwirtschaftliche Arbeitssystem derart auszugestalten und weiterzubilden, dass das Zusammenarbeiten mehrerer Funktionseinheiten des landwirtschaftlichen Arbeitssystems bei der Durchführung landwirtschaftlicher Arbeitsabläufe weiter optimiert wird.

Das obige Problem wird bei einem landwirtschaftlichen Arbeitssystem gemäß dem Oberbegriff von Anspruch 1 durch die Merkmale des kennzeichnenden Teils von Anspruch 1 gelöst.

Das vorschlagsgemäße landwirtschaftliche Arbeitssystem weist mehrere Funktionseinheiten zur Durchführung oder Unterstützung landwirtschaftlicher Arbeit auf. Bei den Funktionseinheiten kann es sich, wie im Weiteren noch erläutert wird, um einzelne landwirtschaftliche Arbeitseinheiten, aber auch um einzelne Arbeitsaggregate zur Durchführung oder Unterstützung landwirtschaftlicher Arbeit innerhalb einer landwirtschaftlichen Arbeitseinheit handeln. Auch Kombinationen davon sind denkbar, das heißt, mindestens eine Funktionseinheit wird von einer landwirtschaftlichen Arbeitseinheit gebildet und mindestens eine weitere Funktionseinheit von einem Arbeitsaggregat innerhalb einer landwirtschaftlichen Arbeitseinheit. In einer bestimmten Arbeitssituation arbeiten immer mehrere Funktionseinheiten zusammen, um einen landwirtschaftlichen Arbeitsablauf durchzuführen. Beispielsweise arbeiten mehrere landwirtschaftliche Arbeitseinheiten miteinander zusammen oder es arbeiten mehrere Arbeitsaggregate innerhalb einer landwirtschaftlichen Arbeitseinheit als Funktionseinheiten zusammen.

Unter einer landwirtschaftlichen Arbeitseinheit wird eine mobile oder stationäre landwirtschaftliche Einrichtung verstanden, die zur Abarbeitung eines landwirtschaftlichen Arbeitsauftrags allein oder zusammen mit einer anderen landwirtschaftlichen Arbeitseinheit dient. Eine landwirtschaftliche Arbeitseinheit im vorschlagsgemäßen Sinne ist insbesondere eine landwirtschaftliche Arbeitsmaschine, beispielsweise eine Zugmaschine, ein Mähdrescher, ein Feldhäcksler oder dergleichen. Auch Anbaugeräte zur Kopplung mit einer landwirtschaftlichen Arbeitsmaschine, wie Pflug, Grubber, Egge, Mähwerk, Ballenpresse oder dergleichen, sind landwirtschaftliche Arbeitseinheiten im vorschlagsgemäßen Sinne. Die vorgenannten landwirtschaftlichen Arbeitseinheiten sind mobile landwirtschaftliche Arbeitseinheiten. Grundsätzlich kann eine landwirtschaftliche Arbeitseinheit aber auch eine stationäre landwirtschaftliche Einrichtung wie eine Getreidetrocknungseinrichtung, ein Getreidelager oder dergleichen sein.

Wesentlich ist zunächst die grundsätzliche Überlegung, dass das vorschlagsgemäße landwirtschaftliche Arbeitssystem ein zentrales Mustererkennungssystem aufweist, an das arbeitssituationsspezifische Informationen übertragen werden und das die konkrete Arbeitssituation identifiziert, insbesondere über eine Vergleichs- und/oder Rechenoperation, und den Funktionseinheiten des landwirtschaftlichen Arbeitssystems mitteilt.

Bemerkenswert ist dabei die Tatsache, dass es sich bei dem Mustererkennungssystem um eine zentrale Einrichtung handelt, die für alle Funktionseinheiten gleichermaßen zur Verfügung steht. Mit "allen" Funktionseinheiten sind unabhängig von ihrer Eignung und Verfügbarkeit sämtliche Funktionseinheiten gemeint, die zu dem Zeitpunkt, zu dem das Mustererkennungssystem die Information über die konkrete Arbeitssituation, im Weiteren als "Metainformation" bezeichnet, überträgt, mit diesem datentechnisch verbunden sind, die dann also empfangsbereit sind und sich in Empfangsreichweite befinden. Die Metainformation wird also nicht zwangsläufig nur an die Funktionseinheiten übertragen, die in der identifizierten Arbeitssituation miteinander zusammenarbeiten, sondern es kann auch vorgesehen sein, dass weitere Funktionseinheiten, die zur Durchführung anderer Aufgaben dienen und somit ungeeignet sind oder die andere Aufgaben durchführen und somit nicht verfügbar sind, die Metainformation erhalten. Das Mustererkennungssystem ist insoweit also ein übergeordnetes Informationssystem, das zentral arbeitssituationsspezifische Informationen sammelt und verarbeitet. Ebenfalls teilt dann das Mustererkennungssystem als zentrale Einrichtung allen Funktionseinheiten die identifizierte Arbeitssituation mit.

Diese an alle Funktionseinheiten übertragene Mitteilung der identifizierten Arbeitssituation (Metainformation) beschränkt sich vorzugsweise auf die reine Angabe der identifizierten Arbeitssituation und beinhaltet dementsprechend insbesondere keine Arbeitsanweisungen. Entsprechend umfasst die Metainformation vorzugsweise keine Parameter, Parametersätze oder Parameterfolgen (sich in zeitlicher Folge ändernde Parameter) zur Steuerung der jeweiligen Funktionseinheit und/oder keine Verweise auf in der jeweiligen Funktionseinheit hinterlegte Parameter, Parametersätze oder Parameterfolgen zur Steuerung der jeweiligen Funktionseinheit. Vielmehr weist die Funktionseinheit eine eigene Steuerungseinrichtung und vorzugsweise ein eigenes hinterlegtes Regelwerk auf, das allein anhand der erhaltenen Bezeichnung und/oder Beschreibung der identifizierten Arbeitssituation selbst entsprechende Parameter, Parametersätze oder Parameterfolgen erzeugt und zur Steuerung der zugehörigen Funktionseinheit anwendet. Die von der Funktionseinheit empfangene Metainformation ist also vorzugsweise lediglich ein Trigger, der bei der Funktionseinheit eine interne Einstellung von Parametern auslöst. Grundsätzlich kann die Metainformation zusätzlich auch noch weitere Daten beinhalten, was im weiteren noch näher erläutert wird.

Weiter ist wesentlich, dass von allen Funktionseinheiten, die die Metainformation erhalten, das Zusammenwirken derjenigen Funktionseinheiten, die in der identifizierten Arbeitssituation miteinander zusammenarbeiten, koordiniert wird. Eine Koordination erfolgt insbesondere mit Hilfe einer Kommunikation, das heißt eines Datenaustausches, direkt zwischen den jeweils zusammenarbeitenden Funktionseinheiten, kann aber auch durch eine Kommunikation zwischen dem Mustererkennungssystem einerseits und den jeweils zusammenarbeitenden Funktionseinheiten andererseits erfolgen.

Im Einzelnen wird vorgeschlagen, dass das landwirtschaftliche Arbeitssystem ein zentrales Mustererkennungssystem aufweist, das derart konfiguriert ist, dass mindestens eine landwirtschaftliche Arbeitssituation in dem Mustererkennungssystem als Situationsmuster hinterlegt ist, dem Mustererkennungssystem arbeitssituationsspezifische Informationen übergebbar sind, das Mustererkennungssystem basierend auf den erhaltenen arbeitssituationsspezifischen Informationen eine hinterlegte Arbeitssituation und das zugehörige Situationsmuster identifiziert und eine die identifizierte Arbeitssituation charakterisierende Meta-information an die Funktionseinheiten überträgt, und dass das Mustererkennungssystem und/oder die Steuerungseinrichtungen der mehreren Funktionseinheiten konfiguriert ist bzw. sind, das Zusammenwirken derjenigen Funktionseinheiten, die in der identifizierten Arbeitssituation zusammenarbeiten, basierend auf der Metainformation zu koordinieren, sodass die Steuerungseinrichtungen Parametereinstellungen der zugehörigen Funktionseinheit vornehmen. Vorzugsweise wird das Zusammenwirken dieser Funktionseinheiten allein basierend auf der Bezeichnung und/oder Beschreibung der identifizierten Arbeitssituation koordiniert. Alternativ kann aber auch vorgesehen sein, dass das Zusammenwirken der Funktionseinheiten unter zusätzlicher Berücksichtigung weiterer vom Mustererkennungssystem an alle Funktionseinheiten übertragener Daten koordiniert wird, was im Weiteren noch näher beschrieben wird.

Das vorschlagsgemäße landwirtschaftliche Arbeitssystem erlaubt eine zentrale Situationserkennung, wobei arbeitssituationsspezifische Informationen aus unterschiedlichen Quellen bzw. von unterschiedlichen Teilsystemen aufgenommen werden können, wobei ein Ergebnis eines darauf erfolgenden Mustererkennungsprozesses in Form der genannten Metainformation an die Teilsysteme zurückgespiegelt werden kann. Es kann so eine einheitliche Arbeitssituation bestimmt werden, die von allen Teilsystemen, den sogenannten Funktionseinheiten, genutzt und/oder beeinflusst werden kann.

Nach der Ausgestaltung gemäß Anspruch 2 kann die Koordination derjenigen Funktionseinheiten, die in der identifizierten Arbeitssituation zusammenarbeiten, durch das Mustererkennungssystem und/oder durch die Funktionseinheiten selbst, das heißt durch deren Steuerungseinrichtungen, erfolgen.

Anspruch 3 definiert den bevorzugten Inhalt der Metainformation. Besonders bevorzugt beinhaltet die Metainformation ausschließlich Daten, die eine Bezeichnung und/oder Beschreibung der Arbeitssituation darstellen. Zusätzlich können gemäß einer weiteren Ausgestaltung aber auch Parameter, Parametersätze oder Parameterfolgen und/oder Verweise auf hinterlegte Parameter, Parametersätze oder Parameterfolgen Bestandteil der Metainformation sein. Diese zusätzlichen Daten stellen dann insbesondere nur eine Empfehlung für die jeweilige Steuereinrichtung dar, das heißt, die Steuereinrichtung entscheidet in diesem Fall selbst, ob sie die zusätzlichen Daten für die Vornahme der Parametereinstellungen berücksichtigt. Es kann aber auch vorgesehen sein, dass die Steuereinrichtung gezwungen wird, die zusätzlichen Daten für die Vornahme der Parametereinstellungen zu berücksichtigen, sodass das Mustererkennungssystem insoweit also als "Master" fungiert.

In Anspruch 4 sind verschiedene Arbeitssituationen definiert, die von dem Mustererkennungssystem identifiziert werden können und deren Bezeichnung und/oder Beschreibung in Form der Metainformation an die Funktionseinheiten übertragen werden kann. Eine solche Arbeitssituation kann beispielsweise die Arbeitssituation "Freischneiden", die Arbeitssituation "Abernten entlang einer Fahrspur im Feld", die Arbeitssituation "Annäherung an ein Vorgewende", die Arbeitssituation "Vorgewende", die Arbeitssituation "Annäherung an ein Hindernis", die Arbeitssituation "Begleitfahrt", die Arbeitssituation "Überladevorgang", die Arbeitssituation "Getreidebergung", die Arbeitssituation "Strohballenerzeugung" und/oder die Arbeitssituation "Strohballenbergung" sein.

Die Ansprüche 5 und 6 definieren die bevorzugten Arten von Funktionseinheiten, die Teil des vorschlagsgemäßen landwirtschaftlichen Arbeitssystems sind und von dem zentralen Mustererkennungssystem die Metainformation erhalten, woraufhin die Funktionseinheiten dann auf direktem Weg untereinander die Zusammenarbeit koordinieren oder das Mustererkennungssystem die Zusammenarbeit zwischen den Funktionseinheiten koordiniert. Danach sind die Funktionseinheiten insbesondere landwirtschaftliche Arbeitseinheiten oder Arbeitsaggregate einer landwirtschaftlichen Arbeitseinheit. Grundsätzlich ist es auch denkbar, dass eine der Funktionseinheiten eine landwirtschaftliche Arbeitseinheit und eine andere der Funktionseinheiten ein Arbeitsaggregat, gegebenenfalls auch eine andere landwirtschaftliche Arbeitseinheit, ist.

Nach der besonders bevorzugten Ausgestaltung gemäß Anspruch 7 kann das Mustererkennungssystem die arbeitssituationsspezifischen Informationen von Sensoren einzelner oder mehrerer landwirtschaftlicher Arbeitseinheiten empfangen. Besonders bevorzugt stellen mehrere landwirtschaftliche Arbeitseinheiten, die insbesondere jeweils eine Funktionseinheit des vorschlagsgemäßen Arbeitssystems bilden, dem Mustererkennungssystem einzelne oder mehrere arbeitssituationsspezifische Informationen zur Verfügung. Zusätzlich oder alternativ ist auch eine bedienerseitige Eingabe von arbeitssituationsspezifischen Informationen denkbar. Durch viele verschiedene Quellen zur Erfassung von arbeitssituationsspezifischen Informationen erhält das Mustererkennungssystem besonders genaue Angaben über die Arbeitssituation. Entsprechend lässt sich das Risiko einer Fehlidentifizierung einer Arbeitssituation bzw. eines zugehörigen Situationsmusters minimieren. Dies gelingt umso besser, je mehr situationsabhängige Informationen und je mehr Funktionseinheiten verfügbar sind, um arbeitssituationsspezifische Informationen, insbesondere sensorisch, zu ermitteln.

Die Ansprüche 8 und 9 definieren bevorzugte Möglichkeiten der Ausgestaltung und des Funktionsumfangs des Mustererkennungssystems. Besonders bevorzugt ist dieses jedenfalls teilweise, insbesondere vollständig, cloudbasiert.

Die Ansprüche 10 bis 12 definieren wiederum bevorzugte Möglichkeiten der Ausgestaltung und des Funktionsumfangs der Funktionseinheiten und insbesondere deren jeweiliger Steuerungseinrichtung.

Nach der besonders bevorzugten Ausgestaltung gemäß Anspruch 13 beinhalten die arbeitssituationsspezifischen Informationen, die an das Mustererkennungssystem übertragen werden, Informationen aus einer oder mehreren Situationsebenen. So können arbeitssituationsspezifische Informationen insbesondere zu mindestens einer Hauptarbeitssituation, mindestens einer Nebenarbeitssituation, mindestens einer Vortriebsituation, mindestens einer Maschinensituation, mindestens einer Sicherheitssituation, mindestens einem Automatiklevel, mindestens einer Simulationssituation und/oder mindestens einer Beladungssituation ermittelt werden. Die Informationsinhalte der arbeitssituationsspezifischen Informationen sind also vorzugsweise strukturiert, wobei die Struktur besonders bevorzugt Grunddaten, nämlich die Hauptarbeitssituation definierende Daten, und spezifische Daten, die nämlich eine oder mehrere der weiteren Situationsebenen definieren, beinhaltet.

Nach der weiter bevorzugten Ausgestaltung gemäß Anspruch 14 erfolgt der Datenaustausch zwischen Mustererkennungssystem und jeweiliger Funktionseinheit und/oder zwischen Funktionseinheiten in Echtzeit. Der Begriff "Echtzeit" ist in diesem Zusammenhang weit zu verstehen und bedeutet, dass das Empfangen der Daten bzw. Informationen in einen vorgegebenen Zeitraum ab dem Senden und/oder Generieren der Daten erfolgt, der höchstens eine halbe Stunde, bevorzugt höchstens wenige Sekunden, zum Beispiel höchstens 30 Sekunden, besonders bevorzugt höchstens wenige Bruchteile von Sekunden, zum Beispiel höchstens eine halbe Sekunde, beträgt.

Nach der ebenfalls bevorzugten Ausgestaltung gemäß Anspruch 15 ist das landwirtschaftliche Arbeitssystem um weitere wie zuvor beschriebene Funktionseinheiten erweiterbar, insoweit also modular aufgebaut.

Nach einer weiteren Lehre gemäß Anspruch 16, der eigenständige Bedeutung zukommt, wird ein Verfahren zur Optimierung von landwirtschaftlichen Arbeitsabläufen unter Verwendung eines landwirtschaftlichen Arbeitssystems, insbesondere eines vorschlagsgemäßen landwirtschaftlichen Arbeitssystems, beansprucht. Dabei ist vorschlagsgemäß vorgesehen, dass das landwirtschaftliche Arbeitssystem ein zentrales Mustererkennungssystem aufweist, in dem mindestens eine landwirtschaftliche Arbeitssituation als Situationsmuster hinterlegt ist, wobei dem Mustererkennungssystem arbeitssituationsspezifische Informationen übergeben werden, das Mustererkennungssystem basierend auf den erhaltenen arbeitssituationsspezifischen Informationen eine hinterlegte Arbeitssituation und das zugehörige Situationsmuster identifiziert und eine die identifizierte Arbeitssituation charakterisierende Metainformation an die mehreren Funktionseinheiten überträgt, und dass das Mustererkennungssystem und/oder die Steuerungseinrichtungen der mehreren Funktionseinheiten das Zusammenwirken derjenigen Funktionseinheiten, die in der identifizierten Arbeitssituation zusammenarbeiten, basierend auf der Metainformation koordiniert bzw. koordinieren, sodass die Steuerungseinrichtungen entsprechende Parametereinstellungen der zugehörigen Funktionseinheit vornehmen. Es darf auf alle Ausführungen zu dem vorschlagsgemäßen landwirtschaftlichen Arbeitssystem verwiesen werden.

Anspruch 17 definiert die besonders bevorzugte Anwendung des Verfahrens im Hinblick auf die Arbeitssituation "Freischneiden".

Nach der bevorzugten Ausgestaltung gemäß Anspruch 18 werden dem Mustererkennungssystem arbeitssituationsspezifische Informationen von einer oder mehreren der Einrichtungen zur Erfassung von arbeitssituationsspezifischen Informationen übergeben, insbesondere von den Arbeitseinheiten, den Funktionseinheiten, den Sensoren, den Eingabeeinrichtungen und/oder von weiteren Einrichtungen, wobei vorzugsweise das Mustererkennungssystem die arbeitssituationsspezifischen Informationen bzw. eine entsprechende Metainformation an einzelne oder mehrere dieser Einrichtungen, insbesondere alle Einrichtungen, zurücküberträgt.

Im Folgenden wird die Erfindung anhand einer lediglich Ausführungsbeispiele darstellenden Zeichnung näher erläutert. In der Zeichnung zeigt
- Fig. 1: eine schematische Darstellung eines vorschlagsgemäßen landwirtschaftlichen Arbeitssystems,
- Fig. 2: eine schematische Darstellung von Anwendungsfällen des vorschlagsgemäßen landwirtschaftlichen Arbeitssystems und
- Fig. 3: eine schematische Darstellung der Kommunikation zwischen dem Mustererkennungssystem und einzelnen Funktionseinheiten des vorschlagsgemäßen landwirtschaftlichen Arbeitssystems.

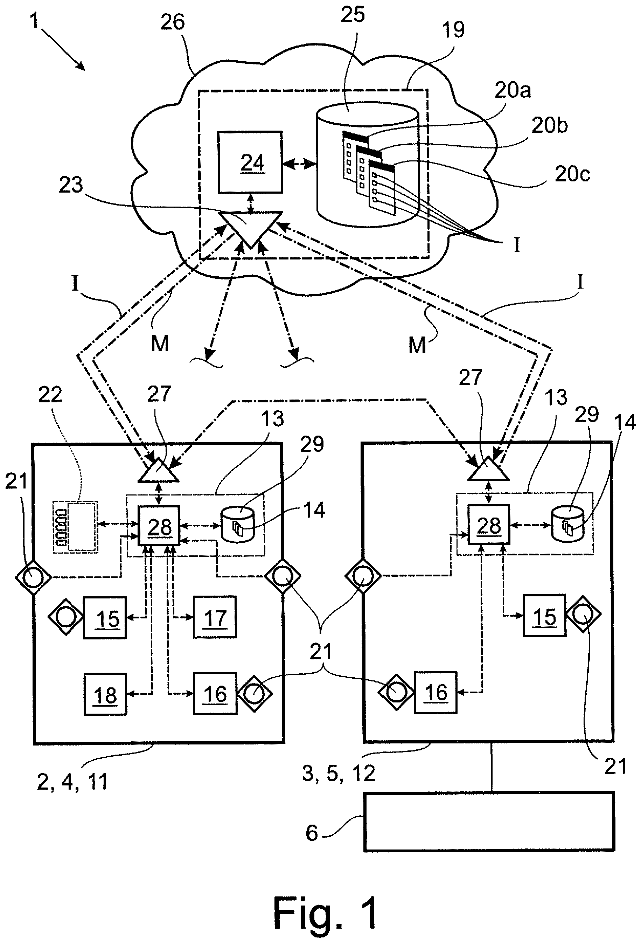

Fig. 1 zeigt schematisch anhand eines Ausführungsbeispiels den grundsätzlichen Aufbau des vorschlagsgemäßen landwirtschaftlichen Arbeitssystems 1 zur Optimierung von landwirtschaftlichen Arbeitsabläufen. Das landwirtschaftliche Arbeitssystem 1 weist mindestens eine landwirtschaftliche Arbeitseinheit 2, 3, hier zwei landwirtschaftliche Arbeitseinheiten 2, 3, auf. In dem hier dargestellten Ausführungsbeispiel handelt es sich bei beiden landwirtschaftlichen Arbeitseinheiten 2, 3 jeweils um eine landwirtschaftliche Arbeitsmaschine, in der Darstellung links unten beispielsweise um einen Mähdrescher 4 und in der Darstellung rechts unten beispielsweise um einen Traktor 5 mit einem Transportanhänger 6 als Anbaugerät. Die landwirtschaftliche Arbeitseinheit 2, 3 kann statt von einer landwirtschaftlichen Arbeitsmaschine auch von einem Anbaugerät als solches gebildet werden, beispielsweise von einem Pflug, einem Grubber, einer Egge, einem Mähwerk, einer Ballenpresse 7 oder dergleichen. Zusätzlich oder alternativ kann im vorschlagsgemäßen Sinne eine landwirtschaftliche Arbeitseinheit 2, 3 auch von einer stationären landwirtschaftlichen Einrichtung wie einer Getreidetrocknungseinrichtung 8, einem Getreidelager 9, einem Werkstattbereich 10 oder dergleichen gebildet werden.

Das vorschlagsgemäße landwirtschaftliche Arbeitssystem 1 weist mehrere Funktionseinheiten 11, 12 zur Durchführung oder Unterstützung landwirtschaftlicher Arbeit auf, die jeweils eine Steuerungseinrichtung 13 zur Steuerung der jeweiligen Funktionseinheit 11, 12, insbesondere basierend auf einem hinterlegten Regelwerk 14, aufweisen. Im hier dargestellten Ausführungsbeispiel sind die Funktionseinheiten 11, 12 identisch mit den landwirtschaftlichen Arbeitseinheiten 2, 3, das heißt, die eine Funktionseinheit 11 wird von dem Mähdrescher 4 und die andere Funktionseinheit 12 von dem Traktor 5 gebildet. Hier und vorzugsweise weist jede der Funktionseinheiten 11, 12 jeweils ein oder mehrere Arbeitsaggregate zur Durchführung oder Unterstützung landwirtschaftlicher Arbeit auf. Arbeitsaggregate im vorschlagsgemäßen Sinne sind insbesondere ein Fahrantrieb 15 der landwirtschaftlichen Arbeitsmaschine, ein Lenksystem 16 der landwirtschaftlichen Arbeitsmaschine, ein Erntegut verarbeitendes Arbeitsaggregat wie ein Schneidwerk 17, ein Dreschwerk und/oder eine Überladeeinrichtung 18 oder auch ein Fahrerassistenzsystem der landwirtschaftlichen Arbeitsmaschine, das insbesondere mehrere der Arbeitsaggregate während der landwirtschaftlichen Arbeitsabläufe regelt und insbesondere auch die Steuerungseinrichtung 13 umfasst.

In einem alternativen, hier nicht dargestellten Ausführungsbeispiel kann auch das Anbaugerät Arbeitsaggregate aufweisen. Beispielsweise kann eine Ballenpresse eine Erntegutaufnahmeeinrichtung und eine Erntegutpresseinrichtung aufweisen. Auch eine stationäre landwirtschaftliche Einrichtung kann als Funktionseinheit Arbeitsaggregate aufweisen. Beispielsweise kann eine Getreidetrocknungseinrichtung eine Getreidezuführeinrichtung und eine Heizeinrichtung aufweisen.

Das vorschlagsgemäße landwirtschaftliche Arbeitssystem 1 weist ferner ein zentrales Mustererkennungssystem 19 auf. In dem Mustererkennungssystem 19 ist mindestens eine landwirtschaftliche Arbeitssituation als ein Situationsmuster 20a, 20b, 20c hinterlegt. Hier sind beispielhaft drei verschiedene Situationsmuster 20a, 20b, 20c hinterlegt, die jeweils eine andere Arbeitssituation darstellen. Eine Arbeitssituation im vorschlagsgemäßen Sinne ist eine bestimmte Situation, in der ein bestimmter landwirtschaftlicher Arbeitsablauf als Teil eines Arbeitsauftrags durchzuführen ist. Lediglich beispielhaft und nicht abschließend sei hier die Arbeitssituation beim Freischneiden, die Arbeitssituation beim Abernten entlang einer Fahrspur im Feld, die Arbeitssituation bei der Annäherung an ein Vorgewende, die Arbeitssituation im Vorgewende, die Arbeitssituation bei der Annäherung an ein Hindernis, die Arbeitssituation bei einer Begleitfahrt, beispielsweise zum Zwecke des Überladens, die Arbeitssituation beim Überladevorgang, die Arbeitssituation bei der Getreidebergung, die Arbeitssituation bei der Strohballenerzeugung oder die Arbeitssituation bei der Strohballenbergung genannt. Jede dieser Arbeitssituationen erfordert einen bestimmten Arbeitsablauf, der wiederum Parametereinstellungen einzelner oder mehrerer Arbeitsaggregate einer landwirtschaftlichen Arbeitseinheit 2, 3, beispielsweise einer landwirtschaftlichen Arbeitsmaschine, erfordert. Fig. 1 stellt beispielhaft und rein schematisch einen Überladevorgang dar, bei dem ein Mähdrescher 4 als eine Funktionseinheit 11 neben einem Traktor 5 herfährt, der eine weitere Funktionseinheit 12 bildet und zur Aufnahme des Korns vom Mähdrescher 4 mit einem Transportanhänger 6 als Anbaugerät gekoppelt ist. In dieser Arbeitssituation muss beispielsweise die jeweilige Steuerungseinrichtung 13 den jeweiligen Fahrantrieb 15 und das jeweilige Lenksystem 16 steuern. Dabei müssen die Antriebsbewegungen der beiden Fahrantriebe 15 und die Lenkbewegungen der beiden Lenksysteme 16 koordiniert werden. Weiterhin muss bei der vom Mähdrescher 4 gebildeten Funktionseinheit 11 unter anderem das Schneidwerk 17 und die Überladeeinrichtung 18 angesteuert werden. Auch die Bewegungen dieser beiden Einrichtungen 17, 18 müssen koordiniert werden.

Um nun den in dieser Arbeitssituation notwendigen Arbeitsablauf der beiden landwirtschaftlichen Arbeitseinheiten 2, 3, also hier des Mähdreschers 4 und des Traktors 5, zu optimieren, werden an das Mustererkennungssystem 19 mehrere, insbesondere eine Vielzahl von arbeitssituationsspezifischen Informationen I übergeben. Die arbeitssituationsspezifischen Informationen I sind Informationen bzw. Daten, die mit der bevorstehenden und/oder gerade vorhandenen Arbeitssituation im Zusammenhang stehen und/oder die geeignet sind, die bevorstehende und/oder gerade vorhandene Arbeitssituation zu definieren. Die arbeitssituationsspezifischen Informationen I werden dabei hier und vorzugsweise von den Funktionseinheiten 11, 12 selbst, gegebenenfalls auch noch von weiteren Funktionseinheiten des landwirtschaftlichen Arbeitssystems 1, ermittelt und dem Mustererkennungssystem 19 übergeben.

Das Mustererkennungssystem 19 ist dabei so konfiguriert, dass es basierend auf den erhaltenen arbeitssituationsspezifischen Informationen I eine hinterlegte Arbeitssituation und das zugehörige Situationsmuster 20a, 20b, 20c identifiziert. Insbesondere gleicht das Mustererkennungssystem 19 dabei die einzelnen erhaltenen Informationen mit den hinterlegten Situationsmustern 20a, 20b, 20c ab. Ist anhand der Informationen ein passendes Situationsmuster 20a, 20b, 20c identifiziert worden, überträgt das Mustererkennungssystem 19 eine die identifizierte Arbeitssituation charakterisierende Metainformation M an die mehreren Funktionseinheiten 11, 12. Die Metainformation M stellt eine Mitteilung der identifizierten Arbeitssituation dar, die sich hier und vorzugsweise auf die reine Angabe der identifizierten Arbeitssituation in Form der Bezeichnung oder einer Beschreibung der Arbeitssituation beschränkt und dementsprechend insbesondere keine Arbeitsanweisungen beinhaltet. Entsprechend umfasst die Metainformation vorzugsweise keine Parameter, Parametersätze oder Parameterfolgen (sich in zeitlicher Folge ändernde Parameter) zur Steuerung der jeweiligen Funktionseinheit und/oder keine Verweise auf in der jeweiligen Funktionseinheit hinterlegte Parameter, Parametersätze oder Parameterfolgen zur Steuerung der jeweiligen Funktionseinheit. Vielmehr müssen hier und vorzugsweise die Funktionseinheiten 11, 12 selbst anhand der mitgeteilten Arbeitssituation, also der Metainformation M, entsprechende Parameter, Parametersätze oder Parameterfolgen für die identifizierte Arbeitssituation generieren und entsprechende Parametereinstellungen vornehmen.

In einem alternativen, hier nicht dargestellten Ausführungsbeispiel kann auch vorgesehen sein, dass die Metainformation M, zusätzlich zu den eine Bezeichnung und/oder Beschreibung der Arbeitssituation darstellenden Daten, auch Parameter, Parametersätze oder Parameterfolgen zur Steuerung der jeweiligen Funktionseinheit 11, 12 und/oder Verweise auf in der jeweiligen Funktionseinheit 11, 12 hinterlegte Parameter, Parametersätze oder Parameterfolgen zur Steuerung der jeweiligen Funktionseinheit 11, 12 beinhaltet.

Die Metainformation M beinhaltet insbesondere Daten, die eine Bezeichnung und/oder Beschreibung der Arbeitssituation "Freischneiden", der Arbeitssituation "Abernten entlang einer Fahrspur im Feld", der Arbeitssituation "Annäherung an ein Vorgewende", der Arbeitssituation "Vorgewende", der Arbeitssituation "Annäherung an ein Hindernis", der Arbeitssituation "Begleitfahrt", der Arbeitssituation "Überladevorgang",der Arbeitssituation "Getreidebergung", der Arbeitssituation "Strohballenerzeugung" und/oder der Arbeitssituation "Strohballenbergung" darstellen.

Es sei hervorgehoben, dass die Metainformation M, die von dem Mustererkennungssystem 19 erzeugt und übermittelt wird, nicht zwingend nur an die beiden miteinander in der jeweiligen Arbeitssituation zusammenarbeitenden Funktionseinheiten 11, 12 übermittelt wird, sondern auch an andere Funktionseinheiten des landwirtschaftlichen Arbeitssystems 1 übermittelt werden kann, was in Fig. 1 anhand zweier Pfeile symbolisiert ist, die von dem Mustererkennungssystem 19 ausgehen und zu keiner der dargestellten Funktionseinheiten führen. Alle Funktionseinheiten des landwirtschaftlichen Arbeitssystems 1 erkennen insbesondere selbständig, ob sie die empfangene Metainformation M selbst betrifft. Nur in dem Fall, dass sie die Metainformation M betrifft, wie hier bei den Funktionseinheiten 11, 12, reagiert die jeweilige Steuerungseinrichtung 13.

Dazu sind hier und vorzugsweise die Steuerungseinrichtungen 13 der mehreren Funktionseinheiten 11, 12 konfiguriert, das Zusammenwirken derjenigen Funktionseinheiten 11, 12, die in der identifizierten Arbeitssituation zusammenarbeiten, basierend auf der Metainformation M zu koordinieren. Im Zuge dieser Koordination nehmen die Steuerungseinrichtungen 13 entsprechende Parametereinstellungen der zugehörigen Funktionseinheit 11, 12 vor. Die Metainformation M ist also hier und vorzugsweise ein Trigger, der die Steuerungseinrichtungen 13 aktiviert, wodurch diese dann Parameter, Parametersätze und/oder Parameterfolgen generieren und entsprechende Parametereinstellungen vornehmen. Es kann zusätzlich oder alternativ auch vorgesehen sein, dass das Mustererkennungssystem 19 konfiguriert ist, das Zusammenwirken derjenigen Funktionseinheiten 11, 12, die in der identifizierten Arbeitssituation zusammenarbeiten, basierend auf der Metainformation M zu koordinieren. Auch dann nehmen die Steuerungseinrichtungen 13 entsprechende Parametereinstellungen der zugehörigen Funktionseinheit 11, 12 vor.

Wie bereits zuvor erläutert, können die Funktionseinheiten 11, 12 von verschiedenen landwirtschaftlichen Arbeitseinheiten 2, 3 gebildet werden. Funktionseinheiten 11, 12 sind demnach beispielsweise eine landwirtschaftliche Arbeitsmaschine, ein mit einer landwirtschaftlichen Arbeitsmaschine gekoppeltes oder koppelbares Anbaugerät und/oder eine stationäre landwirtschaftliche Einrichtung. In einem alternativen und hier nicht dargestellten Ausführungsbeispiel können die Funktionseinheiten 11, 12 auch von verschiedenen Arbeitsaggregaten einer landwirtschaftlichen Arbeitseinheit 2, 3 gebildet werden. Beispielsweise kann eine Funktionseinheit 11, 12 ein Fahrantrieb 15 der landwirtschaftlichen Arbeitsmaschine, ein Lenksystem 16 der landwirtschaftlichen Arbeitsmaschine, ein Fahrerassistenzsystem der landwirtschaftlichen Arbeitsmaschine, ein Erntegut verarbeitendes Arbeitsaggregat der landwirtschaftlichen Arbeitsmaschine oder der stationären landwirtschaftlichen Einrichtung und/oder ein Erntegut verarbeitendes Arbeitsaggregat des Anbaugeräts sein.

Das Mustererkennungssystem 19 ist hier und vorzugsweise konfiguriert, einzelne oder mehrere arbeitssituationsspezifische Informationen I von Sensoren 21 der mindestens einen landwirtschaftlichen Arbeitseinheit 2, 3 oder mehrerer der landwirtschaftlichen Arbeitseinheiten 2, 3 zu empfangen. Es ist hier außerdem optional vorgesehen, dass bedienerseitig über eine Eingabeeinrichtung 22 der landwirtschaftlichen Arbeitseinheit 2, 3 arbeitssituationsspezifische Informationen I eingegeben werden können, die ebenfalls von dem Mustererkennungssystem 19 empfangen werden.

Zum Empfang der arbeitssituationsspezifischen Informationen I und zum Übermitteln der Metainformation M an die Funktionseinheiten 11, 12 weist das Mustererkennungssystem 19 hier und vorzugsweise eine Kommunikationsschnittstelle 23 auf. Weiter weist das Mustererkennungssystem 19 einen Rechner 24 zur Verarbeitung der einzelnen, empfangenen arbeitssituationsspezifischen Informationen I und einen Datenspeicher 25, in dem die Situationsmuster 20a, 20b, 20c hinterlegt sind, auf. Hier und vorzugsweise sind der Rechner 24 und der Datenspeicher 25 Bestandteil einer Cloud 26, werden also über das Internet bereitgestellt. Das Mustererkennungssystem 19 ist also vorzugsweise teilweise oder vollständig cloudbasiert. Es ist aber auch denkbar, dieses maschinenseitig, das heißt in einer landwirtschaftlichen Arbeitsmaschine, und/oder stationär, das heißt ortsgebunden, beispielsweise in einer Datenverarbeitungsanlage auf einem landwirtschaftlichen Betrieb, bereitzustellen.

Auch die Funktionseinheiten 11, 12 weisen vorzugsweise jeweils eine Kommunikationsschnittstelle 27 auf. Diese dient jedenfalls zum Empfang der Metainformation M. Die Kommunikationsschnittstelle 27 kann darüberhinaus auch zur Übertragung von arbeitssituationsspezifischen Informationen I konfiguriert sein. Hier und vorzugsweise ist die Kommunikationsschnittstelle 27 außerdem zum Datenaustausch mit einer Kommunikationsschnittstelle 27 einer anderen Funktionseinheit 11, 12 konfiguriert, wodurch eine Koordination des Zusammenarbeitens auf direktem Weg möglich ist.

Die Steuerungseinrichtungen 13 der Funktionseinheiten 11, 12 weisen hier und vorzugsweise jeweils einen Mikrocontroller 28 zur Verarbeitung der jeweiligen Metainformation M und einen Datenspeicher 29, in dem das Regelwerk 14 hinterlegt ist, auf. Das Regelwerk 14 kann Parameter, Parametersätze und/oder Parameterfolgen für mindestens ein Arbeitsaggregat der landwirtschaftlichen Arbeitseinheit 2, 3 aufweisen, die jeweils verschiedenen Arbeitssituationen zugeordnet sind. Die jeweilige Steuerungseinrichtung 13 kann dann basierend auf der erhaltenen Metainformation M mindestens einen Parameter, mindestens einen Parametersatz und/oder mindestens eine Parameterfolge für mindestens ein Arbeitsaggregat der landwirtschaftlichen Arbeitseinheit 2, 3 einstellen und die mindestens eine Einstellung mit mindestens einer Einstellung einer anderen Funktionseinheit 11, 12, die auf derselben Metainformation M basiert, koordinieren.

Die arbeitssituationsspezifischen Informationen I sind vorzugsweise strukturiert und beinhalten arbeitssituationsspezifischen Informationen I aus einer oder mehreren hierarchisch unterschiedlichen Situationsebenen E, E₀, E₁, etc. So können arbeitssituationsspezifische Informationen I zu mindestens einer Hauptarbeitssituation, mindestens einer Nebenarbeitssituation, mindestens einer Vortriebsituation, mindestens einer Maschinensituation, mindestens einer Sicherheitssituation, mindestens einem Automatiklevel, mindestens einer Simulationssituation und/oder mindestens einer Beladungssituation ermittelt und dem Mustererkennungssystem 19 übermittelt werden.

Eine arbeitssituationsspezifische Informationen I zu einer Hauptarbeitssituation bzw. zu einer Arbeitssituation einer Hauptsituationsebene E₀ kann mindestens eine arbeitssituationsspezifische Information I zur Definition der Vorbereitung eines Arbeitsauftrags und/oder zur Definition der Umgebung (z.B. Straße, Feld) und/oder zur Definition des Arbeitsauftrags (z.B. Getreideernte, Bodenbearbeitung etc.) der landwirtschaftlichen Arbeitseinheit oder einer anderen, insbesondere benachbarten, landwirtschaftlichen Arbeitseinheit beinhalten.

Eine arbeitssituationsspezifische Informationen I zu einer Nebenarbeitssituation bzw. zu einer Arbeitssituation einer untergeordneten Nebensituationsebene E₁ kann mindestens eine arbeitssituationsspezifische Information I zur Definition einer untergeordneten Aufgabe (z.B. Freischneiden, Abernten entlang einer Fahrspur im Feld, Annäherung an ein Vorgewende, Durchfahren eines Vorgewendes, Annäherung an ein Hindernis, Begleitfahrt, Überladevorgang, Getreidebergung, Strohballenerzeugung, Strohballenbergung) der landwirtschaftlichen Arbeitseinheit oder einer anderen, insbesondere benachbarten, landwirtschaftlichen Arbeitseinheit beinhalten.

Eine arbeitssituationsspezifische Informationen I zu einer Vortriebsituation bzw. zu einer Arbeitssituation einer weiter untergeordneten Situationsebene kann mindestens eine arbeitssituationsspezifische Information I zur Definition eines Bewegungs- und/oder Fahrzustands (z.B. Stillstand, stationär, vorwärts, rückwärts) der landwirtschaftlichen Arbeitseinheit oder einer anderen, insbesondere benachbarten, landwirtschaftlichen Arbeitseinheit beinhalten.

Eine arbeitssituationsspezifische Informationen I zu einer Maschinensituation bzw. zu einer Arbeitssituation einer anderen untergeordneten Situationsebene E₁ kann mindestens eine arbeitssituationsspezifische Information I zur Definition eines Maschinenzustands (z.B. Hauptaggregat "an", Hauptaggregat "aus") der landwirtschaftlichen Arbeitseinheit oder einer anderen, insbesondere benachbarten, landwirtschaftlichen Arbeitseinheit beinhalten.

Eine arbeitssituationsspezifische Informationen I zu einer Sicherheitssituation bzw. zu einer Arbeitssituation einer anderen untergeordneten Situationsebene kann mindestens eine arbeitssituationsspezifische Information I zur Definition der funktionalen Sicherheit der landwirtschaftlichen Arbeitseinheit oder einer anderen, insbesondere benachbarten, landwirtschaftlichen Arbeitseinheit beinhalten.

Eine arbeitssituationsspezifische Informationen I zu einem Automatiklevel bzw. zu einer Arbeitssituation einer anderen untergeordneten Situationsebene kann mindestens eine arbeitssituationsspezifische Information I zur Definition eines eingestellten Fahrmodus oder Fahrmodus-Levels (Level 1: interne Automatiken, Level 2: automatische Schneidwerksregelung, Level 3: automatisches Feldfahren, Level 4: ferngesteuertes Feldfahren, Level 5: autonomes Feldfahren, Level 6: Straßenfahrtautomatik) der landwirtschaftlichen Arbeitseinheit oder einer anderen, insbesondere benachbarten, landwirtschaftlichen Arbeitseinheit beinhalten.

Eine arbeitssituationsspezifische Informationen I zu einer Simulationssituation bzw. zu einer Arbeitssituation einer anderen untergeordneten Situationsebene kann mindestens eine arbeitssituationsspezifische Information I zur Definition einer Simulation eines Arbeitsauftrags beinhalten.

Eine arbeitssituationsspezifische Informationen I zu einer Beladungssituation bzw. zu einer Arbeitssituation einer anderen untergeordneten Situationsebene kann mindestens eine arbeitssituationsspezifische Information I zur Definition eines Beladungszustands (z.B. Kapazität erschöpft, volle Kapazität verfügbar) der landwirtschaftlichen Arbeitseinheit oder einer anderen, insbesondere benachbarten, landwirtschaftlichen Arbeitseinheit beinhalten.

Der Datenaustausch zwischen dem Mustererkennungssystem 19 und der jeweiligen Funktionseinheit 11, 12 und/oder der Datenaustausch zwischen den Funktionseinheiten 11, 12 erfolgt hier und vorzugsweise in Echtzeit. Besonders bevorzugt erfolgt der Datenaustausch drahtlos.

Das vorschlagsgemäße landwirtschaftliche Arbeitssystem 1 ist hier und vorzugsweise um weitere Funktionseinheiten (nicht dargestellt) zur Durchführung oder Unterstützung landwirtschaftlicher Arbeit modular erweiterbar. Jede der weiteren Funktionseinheiten kann dabei hinsichtlich des Aufbaus und der Funktionsweise den zuvor beschriebenen Funktionseinheiten 11, 12 entsprechen.

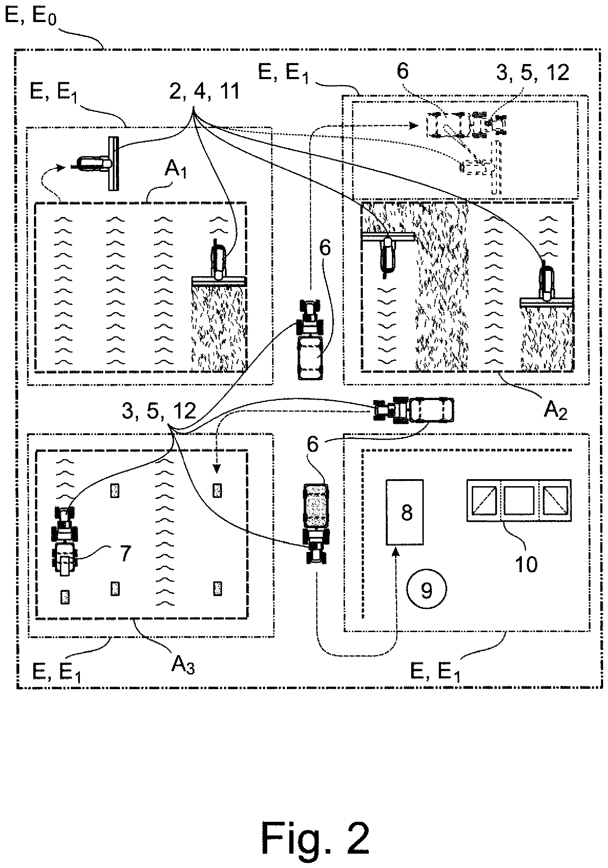

Fig. 2 zeigt das vorschlagsgemäße landwirtschaftliche Arbeitssystem 1 für den landwirtschaftlichen Anwendungsfall der Getreideernte und der entsprechenden untergeordneten Aufgaben wie das Abernten entlang einer Fahrspur im Feld, den Überladevorgang, die Getreidebergung auf dem Betriebshof und die Strohballenerzeugung.

Im rechten unteren Bereich der Fig. 2 ist ein landwirtschaftlicher Betrieb schematisch dargestellt, der neben einer Getreidetrocknungseinrichtung 8 sowie einem Getreidelager 9 einen Werkstattbereich 10 aufweist. Der landwirtschaftliche Betrieb als solcher sowie seine stationären Struktureinheiten Getreidetrocknungseinrichtung 8, Getreidelager 9 und Werkstattbereich 10 bilden stationäre Funktionseinheiten 11, 12 des vorschlagsgemäßen landwirtschaftlichen Arbeitssystems 1.

Über ein beliebig ausgeführtes Straßen- und Wegenetz ist der landwirtschaftliche Betrieb mit einer Vielzahl von zu bearbeitenden Territorien, hier Anbauflächen A₁, A₂, A₃, verbunden.

Auf einer ersten Anbaufläche A₁ sind zwei als Mähdrescher 4 ausgeführte landwirtschaftliche Arbeitsmaschinen im Ernteeinsatz, wobei ein Mähdrescher 4 den Feldbestand und ein weiterer Mähdrescher 4 das Vorgewende durchfährt. Die beiden Mähdrescher 4 bilden weitere, hier mobile, Funktionseinheiten 11, 12 des vorschlagsgemäßen landwirtschaftlichen Arbeitssystems 1. Die Mähdrescher 4 speichern bis zu einem Überladevorgang in an sich üblicher Weise in einem maschinenseitigen Tank die geernteten Fruchtstände, hier Getreidekörner, während das im Ernteprozess anfallende Stroh im rückwärtigen Bereich des Mähdreschers 4 als Schwad auf der Anbaufläche A₁ abgelegt wird.

Auf einer weiteren Anbaufläche A₂ sind, beispielsweise zeitgleich oder zu einem anderen Zeitpunkt, in analoger Weise zwei weitere als Mähdrescher 4 ausgeführte landwirtschaftliche Arbeitsmaschinen im Ernteeinsatz. Diese beiden Mähdrescher 4 bilden noch weitere, hier mobile, Funktionseinheiten 11, 12 des vorschlagsgemäßen landwirtschaftlichen Arbeitssystems 1. Damit spiegelt die dargestellte Bearbeitung von landwirtschaftlichen Arbeitsflächen A₁, A₂ einen typischen Einsatz von Mähdreschern 4 in der Ernte wider, da regelmäßig aus Wirtschaftlichkeitsgründen bei großen Flurstücken A₁, A₂ mehrere landwirtschaftliche Arbeitsmaschinen gemeinsam einen landwirtschaftlichen Arbeitsauftrag ausführen. Dabei ist in Fig. 2 oberhalb der Arbeitsfläche A₂ ein möglicher Überladevorgang zwischen einem der Mähdrescher 4 und einem Gespann aus einem Traktor 5 und einem Transportanhänger 6 dargestellt.

Ferner ist eine weitere Anbaufläche A₃ dargestellt, auf der, beispielsweise zeitgleich oder zu einem anderen Zeitpunkt, eine von einem Traktor 5 gezogene Ballenpresse 7 das in Schwaden abgelegte Erntegut zu Erntegutballen verpresst. Der Traktor 5 bildet noch eine weitere, hier mobile, Funktionseinheit 11, 12 des vorschlagsgemäßen landwirtschaftlichen Arbeitssystems 1.

Schließlich sind auf dem Straßen- und Wegenetz mit dem Ziel des Ladens bzw. Entladens der Fruchtstände entlangfahrende weitere Gespanne aus einem Traktor 5 und einem Transportanhänger 6, der in zwei Fällen leer und in einem Fall gefüllt ist, dargestellt. Jeder dieser Traktoren 5 bildet noch eine weitere, hier mobile, Funktionseinheit 11, 12 des vorschlagsgemäßen landwirtschaftlichen Arbeitssystems 1.

Die in Fig. 2 schematisch dargestellten und zuvor erläuterten Situationen stellen jeweils eine landwirtschaftliche Arbeitssituation im vorschlagsgemäßen Sinne dar. Jeder dieser Arbeitssituationen entspricht dabei ein im zentralen Mustererkennungssystem 19 hinterlegtes Situationsmuster 20a, 20b, 20c, das das Mustererkennungssystem 19 basierend auf empfangenen arbeitssituationsspezifischen Informationen I identifizieren kann. Im Anschluss an die Identifizierung eines bestimmten Situationsmusters 20a, 20b, 20c und entsprechend einer identifizierten Arbeitssituation überträgt das Mustererkennungssystem 19 wie beschrieben eine die identifizierte Arbeitssituation charakterisierende Metainformation M an die in Fig. 2 dargestellten Funktionseinheiten 11, 12.

Beispielsweise wird für den landwirtschaftlichen Betrieb als Arbeitssituation die Übergabe von Getreide an die Getreidetrocknungseinrichtung 8 identifiziert (Situationsmuster "Getreidebergung"). Für die erste Anbaufläche A₁ wird beispielsweise als Arbeitssituation das Abernten eines Feldes, hier eines Getreidefeldes, entlang von Fahrspuren identifiziert (Situationsmuster "Abernten entlang einer Fahrspur im Feld"). Für die zweite Anbaufläche A₂ wird als Arbeitssituation beispielsweise das Überladen von geernteten Fruchtständen, hier Getreidekörnern, identifiziert (Situationsmuster "Überladevorgang"). Für die dritte Anbaufläche A₃ wird beispielsweise als Arbeitssituation das Pressen von Ballen, hier Rundballen, identifiziert (Situationsmuster "Strohballenerzeugung").

Wie bereits erläutert, beinhalten die arbeitssituationsspezifischen Informationen I, die an das Mustererkennungssystem 19 übertragen werden, insbesondere Informationen aus mehreren Situationsebenen E, E₀, E₁, etc. Eine arbeitssituationsspezifische Information I beinhaltet beispielsweise mindestens eine Information zu einer Hauptarbeitssituation und einer Nebenarbeitssituation. Einer Hauptarbeitssituation ist hier in dem Mustererkennungssystem 19 beispielsweise ein übergeordnetes, globales Situationsmuster "Getreideernte" zugeordnet.

Einer Nebenarbeitssituation sind hier in dem Mustererkennungssystem 19 lediglich beispielhaft und nicht abschließend die Situationsmuster "Abernten entlang einer Fahrspur im Feld", "Überladevorgang","Getreidebergung" und "Strohballenerzeugung" zugeordnet.

Sämtliche in Fig. 2 dargestellten Funktionseinheiten 11, 12 bzw. deren Steuerungseinheiten 13 sind nun hier und vorzugsweise derart konfiguriert, dass die Steuerungseinrichtungen 13 derjenigen Funktionseinheiten 11, 12, die in der identifizierten Arbeitssituation zusammenarbeiten, basierend auf der erhaltenen Metainformation M ihr Zusammenarbeiten koordinieren und Parametereinstellungen der zugehörigen Funktionseinheit 11, 12 vornehmen.

Beispielsweise werden basierend auf dem Situationsmuster "Überladevorgang" von den Steuerungseinrichtungen 13 jeder Funktionseinheit 11, 12 unter anderem Parametereinstellungen des Fahrantriebs 15 und des Lenksystems 16 vorgenommen, um zu erreichen, dass sich Mähdrescher 4 und Traktor 5 zu einem optimalen Zeitpunkt in optimaler Ausrichtung zueinander treffen. Die übrigen Funktionseinheiten 11, 12 erhalten zwar auch die Metainformation M, erkennen aber selbständig, dass sie sich in einer anderen Arbeitssituation befinden, und reagieren entsprechend nicht auf die Metainformation M.

Bei einem weiteren Ausführungsbeispiel gibt der Bediener über die Eingabeeinrichtung 22 einer als Mähdrescher ausgestalteten ersten Arbeitseinheit 2, 3 als arbeitssituationsspezifische Informationen I die Arbeitssituation "Freischneiden" vor. Diese arbeitssituationsspezifischen Informationen I werden dann an das Mustererkennungssystem 19 übergeben, das daraufhin basierend auf den erhaltenen arbeitssituationsspezifischen Informationen I die hinterlegte Arbeitssituation "Freischneiden" und das zugehörige Situationsmuster 20a, 20b, 20c identifiziert. Das Mustererkennungssystem 19 erzeugt und überträgt dann eine die identifizierte Arbeitssituation "Freischneiden" charakterisierende Metainformation M an alle jeweils eine Funktionseinheit 11, 12 bildenden weiteren Arbeitseinheiten 2, 3 des landwirtschaftlichen Arbeitssystems 1, darunter insbesondere mindestens ein weiterer Mähdrescher und mindestens ein Abtankfahrzeug.

Das Zusammenwirken der in der Arbeitssituation "Freischneiden" zusammenarbeitenden Arbeitseinheiten 2, 3 wird basierend auf der Metainformation M koordiniert, indem bei der als Mähdrescher ausgestalteten ersten Arbeitseinheit 2, 3 für die Arbeitssituation "Freischneiden" spezifisch vorgesehene Parametereinstellungen vorgenommen werden und/oder indem als weitere Arbeitseinheit 2, 3 für die Arbeitssituation "Freischneiden" ein weiterer Mähdrescher angefordert wird und/oder indem als weitere Arbeitseinheit 2, 3 für eine der Arbeitssituation "Freischneiden" nachfolgende Arbeitssituation "Überladevorgang" ein Abtankfahrzeug angefordert wird.

Das vorschlagsgemäße landwirtschaftliche Arbeitssystem ist, wie zuvor bereits erläutert, allgemein so ausgestaltet, dass dem Mustererkennungssystem 19 von einer oder mehreren Einrichtungen zur Erfassung von arbeitssituationsspezifischen Informationen I einzelne oder mehrere arbeitssituationsspezifische Informationen I übergeben werden. Besonders bevorzugt werden dem Mustererkennungssystem 19 die arbeitssituationsspezifischen Informationen I von einer oder mehreren Arbeitseinheiten 2, 3, von einer oder mehreren Funktionseinheiten 11, 12, von einem oder mehreren Sensoren 21 mindestens einer der Arbeitseinheiten 2, 3, von einer oder mehreren Eingabeeinrichtungen 22 zur bedienerseitigen Eingabe von arbeitssituationsspezifischen Informationen I und/oder von einer oder mehreren weiteren Einrichtungen zur Erfassung von arbeitssituationsspezifischen Informationen I übergeben. Hier und vorzugsweise überträgt das Mustererkennungssystem 19 die übergebenen arbeitssituationsspezifischen Informationen I und/oder die basierend darauf vom Mustererkennungssystem 19 erzeugte Metainformation M an einzelne oder mehrere dieser Einrichtungen, insbesondere alle Einrichtungen, zurück.

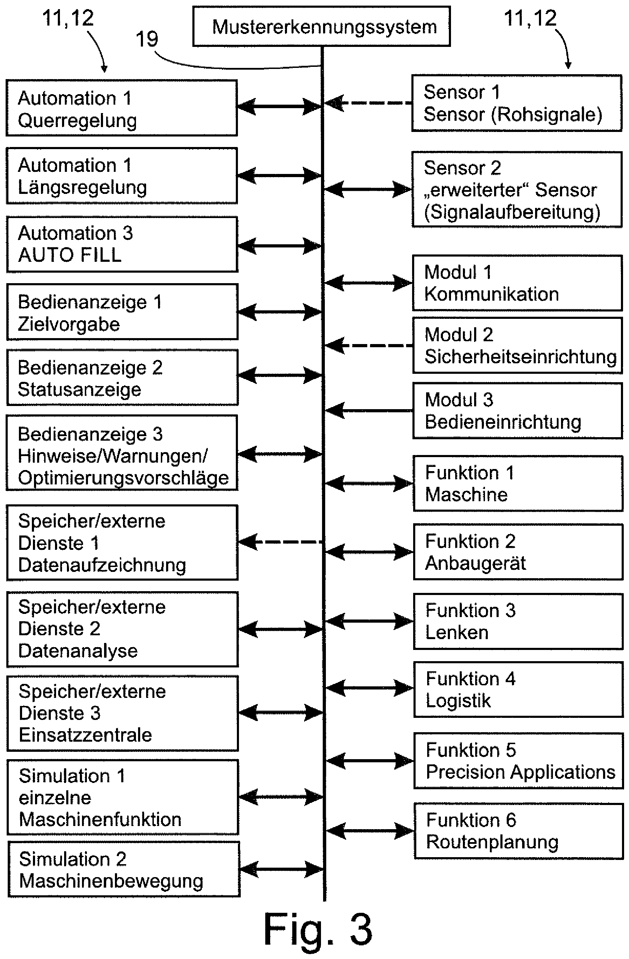

In Fig. 3 ist schließlich schematisch die Kommunikation zwischen dem Mustererkennungssystem 19 und einzelnen Funktionseinheiten 11, 12 des vorschlagsgemäßen landwirtschaftlichen Arbeitssystems 1 dargestellt. Die Kommunikation ist bei einigen Funktionseinheiten 11, 12 bidirektional (durch Doppelpfeil dargestellt), erfolgt also zwischen Mustererkennungssystem 19 und Funktionseinheit 11, 12 in beiden Richtungen. Bei anderen Funktionseinheiten 11, 12 ist die Kommunikation unidirektional (durch einfachen Pfeil dargestellt), erfolgt also entweder nur vom Mustererkennungssystem 19 zur Funktionseinheit 11, 12 oder nur von der Funktionseinheit 11, 12 zum Mustererkennungssystem 19. Optionale Kommunikationswege sind gestrichelt dargestellt.

Auf der linken Seite sind als Funktionseinheiten 11, 12 beispielhaft von oben nach unten dargestellt eine Querregelungseinheit, eine Längsregelungseinheit, eine "Auto Fill"-Einheit, eine Bedienanzeige zur Anzeige einer Zielvorgabe, eine Bedienanzeige zur Statusanzeige, eine Bedienanzeige zur Anzeige von Hinweisen, Warnungen und/oder Optimierungsvorschlägen, einen (optionalen) Speicher bzw. externe Dienste zur Datenaufzeichnung, einen Speicher bzw. externe Dienste zur Datenanalyse, einen Speicher bzw. externe Dienste als Einsatzzentrale, eine Simulationseinheit zur Simulation einzelner Maschinenfunktionen sowie eine Simulationseinheit zur Simulation von Maschinenbewegungen.

Auf der rechten Seite sind als weitere Funktionseinheiten 11, 12 beispielhaft von oben nach unten dargestellt eine Sensoreinheit mit mindestens einem Sensor zur Erzeugung von Rohsignalen, eine Sensoreinheit mit mindestens einem erweiterten Sensor mit Signalaufbereitung, ein Modul zur Kommunikation, ein Modul in Form einer Bedieneinrichtung, ein Funktionsmodul in Form der Maschine, ein Funktionsmodul in Form des Anbaugeräts, ein Funktionsmodul in Form eines Lenkmoduls, ein Funktionsmodul in Form eines Logistikmoduls, ein Funktionsmodul in Form eines Optimierungsmoduls (Precision Applications), beispielsweise in Form einer automatischen Teilbreitenschaltung (Section Control) oder in Form einer variablen Ausbringmengensteuerung (Variable Rate Control), sowie ein Funktionsmodul in Form eines Routenplanungsmoduls.

### Bezugszeichenliste

- 1: landwirtschaftliches Arbeitssystem
- 2: landwirtschaftliche Arbeitseinheit
- 3: landwirtschaftliche Arbeitseinheit
- 4: Mähdrescher
- 5: Traktor
- 6: Transportanhänger
- 7: Ballenpresse
- 8: Getreidetrocknungseinrichtung
- 9: Getreidelager
- 10: Werkstattbereich
- 11: Funktionseinheit
- 12: Funktionseinheit
- 13: Steuerungseinrichtung
- 14: Regelwerk
- 15: Fahrantrieb
- 16: Lenksystem
- 17: Schneidwerk
- 18: Überladeeinrichtung
- 19: Mustererkennungssystem
- 20a, 20b, 20c: Situationsmuster
- 21: Sensor
- 22: Eingabeeinrichtung
- 23: Kommunikationsschnittstelle
- 24: Rechner
- 25: Datenspeicher
- 26: Cloud
- 27: Kommunikationsschnittstelle
- 28: Mikrocontroller
- 29: Datenspeicher
- A₁, A₂, A₃: Anbauflächen
- I: arbeitssituationsspezifische Informationen
- M: Metainformation
- E, E₀, E₁: Situationsebenen

## Patentansprüche

1. Landwirtschaftliches Arbeitssystem zur Optimierung von landwirtschaftlichen Arbeitsabläufen mit mindestens einer landwirtschaftlichen Arbeitseinheit (2, 3), insbesondere einer landwirtschaftlichen Arbeitsmaschine und/oder einer stationären landwirtschaftlichen Einrichtung, wobei das landwirtschaftliche Arbeitssystem (1) mehrere Funktionseinheiten (11, 12) zur Durchführung oder Unterstützung landwirtschaftlicher Arbeit aufweist, die jeweils eine Steuerungseinrichtung (13) zur Steuerung der jeweiligen Funktionseinheit (11, 12) basierend auf einem hinterlegten Regelwerk (14) aufweisen,
**dadurch gekennzeichnet,**
**dass** das landwirtschaftliche Arbeitssystem (1) ein zentrales Mustererkennungssystem (19) aufweist, das derart konfiguriert ist, dass mindestens eine landwirtschaftliche Arbeitssituation in dem Mustererkennungssystem (19) als Situationsmuster (20a, 20b, 20c) hinterlegt ist, dem Mustererkennungssystem (19) arbeitssituationsspezifische Informationen (I) übergebbar sind, das Mustererkennungssystem (19) basierend auf den erhaltenen arbeitssituationsspezifischen Informationen (I) eine hinterlegte Arbeitssituation und das zugehörige Situationsmuster (20a, 20b, 20c) identifiziert und eine die identifizierte Arbeitssituation charakterisierende Metainformation (M) an die Funktionseinheiten (11, 12) überträgt, und
**dass** das Mustererkennungssystem (19) und/oder die Steuerungseinrichtungen (13) der mehreren Funktionseinheiten (11, 12) konfiguriert ist/sind, das Zusammenwirken derjenigen Funktionseinheiten (11, 12), die in der identifizierten Arbeitssituation zusammenarbeiten, basierend auf der Metainformation (M) zu koordinieren, sodass die Steuerungseinrichtungen (13) entsprechende Parametereinstellungen der zugehörigen Funktionseinheit (11, 12) vornehmen.

2. Landwirtschaftliches Arbeitssystem nach Anspruch 1, **dadurch gekennzeichnet, dass** das Mustererkennungssystem (19) das Zusammenwirken derjenigen Funktionseinheiten (11, 12), die in der identifizierten Arbeitssituation zusammenarbeiten, basierend auf der Metainformation (M) koordiniert und die Steuerungseinrichtungen (13) dieser Funktionseinheiten (11, 12) entsprechende Parametereinstellungen der zugehörigen Funktionseinheit (11, 12) vornehmen, und/oder,
dass die Steuerungseinrichtungen (13) derjenigen Funktionseinheiten (11, 12), die in der identifizierten Arbeitssituation zusammenarbeiten, das Zusammenwirken dieser Funktionseinheiten (11, 12) basierend auf der erhaltenen Metainformation (M) miteinander koordinieren und Parametereinstellungen der zugehörigen Funktionseinheit (11, 12) vornehmen.

3. Landwirtschaftliches Arbeitssystem nach Anspruch 1 oder 2, **dadurch gekennzeichnet, dass** die Metainformation (M) eine Bezeichnung und/oder Beschreibung der Arbeitssituation darstellende Daten beinhaltet, vorzugsweise, dass die Metainformation (M) ausschließlich eine Bezeichnung und/oder Beschreibung der Arbeitssituation darstellende Daten beinhaltet, oder, dass die Metainformation (M), zusätzlich zu den eine Bezeichnung und/oder Beschreibung der Arbeitssituation darstellenden Daten, auch Parameter, Parametersätze oder Parameterfolgen zur Steuerung der jeweiligen Funktionseinheit (11, 12) und/oder Verweise auf in der jeweiligen Funktionseinheit (11, 12) hinterlegte Parameter, Parametersätze oder Parameterfolgen zur Steuerung der jeweiligen Funktionseinheit (11, 12) beinhaltet.

4. Landwirtschaftliches Arbeitssystem nach einem der vorhergehenden Ansprüche, **dadurch gekennzeichnet, dass** die Metainformation (M) Daten beinhaltet, die eine Bezeichnung und/oder Beschreibung der Arbeitssituation "Freischneiden", der Arbeitssituation "Abernten entlang einer Fahrspur im Feld", der Arbeitssituation "Annäherung an ein Vorgewende", der Arbeitssituation "Vorgewende", der Arbeitssituation "Annäherung an ein Hindernis", der Arbeitssituation "Begleitfahrt", der Arbeitssituation "Überladevorgang",der Arbeitssituation "Getreidebergung", der Arbeitssituation "Strohballenerzeugung" und/oder der Arbeitssituation "Strohballenbergung" darstellen.

5. Landwirtschaftliches Arbeitssystem nach einem der vorhergehenden Ansprüche, **dadurch gekennzeichnet, dass** die mehreren Funktionseinheiten (11, 12) von verschiedenen landwirtschaftlichen Arbeitseinheiten (2, 3) gebildet werden, vorzugsweise, dass mindestens eine Funktionseinheit (11, 12) eine landwirtschaftliche Arbeitsmaschine ist und/oder dass mindestens eine Funktionseinheit (11, 12) ein mit einer landwirtschaftlichen Arbeitsmaschine gekoppeltes oder koppelbares Anbaugerät ist und/oder mindestens eine Funktionseinheit (11, 12) eine stationäre landwirtschaftliche Einrichtung ist.

6. Landwirtschaftliches Arbeitssystem nach einem der vorhergehenden Ansprüche, **dadurch gekennzeichnet, dass** die mehreren Funktionseinheiten (11, 12) von verschiedenen Arbeitsaggregaten einer landwirtschaftlichen Arbeitseinheit (2, 3) gebildet werden, vorzugsweise, dass eine Funktionseinheit (11, 12) ein Fahrantrieb (15) der landwirtschaftlichen Arbeitsmaschine ist und/oder dass eine Funktionseinheit (11, 12) ein Lenksystem (16) der landwirtschaftlichen Arbeitsmaschine ist und/oder dass eine Funktionseinheit (11, 12) ein Fahrerassistenzsystem der landwirtschaftlichen Arbeitsmaschine ist und/oder dass eine Funktionseinheit (11, 12) ein Erntegut verarbeitendes Arbeitsaggregat der landwirtschaftlichen Arbeitsmaschine oder der stationären landwirtschaftlichen Einrichtung ist und/oder dass eine Funktionseinheit (11, 12) ein Erntegut verarbeitendes Arbeitsaggregat des Anbaugeräts ist.

7. Landwirtschaftliches Arbeitssystem nach einem der vorhergehenden Ansprüche, **dadurch gekennzeichnet, dass** das Mustererkennungssystem (19) konfiguriert ist, einzelne oder mehrere arbeitssituationsspezifische Informationen (I) von Sensoren (21) der mindestens einen landwirtschaftlichen Arbeitseinheit (2, 3) oder mehrerer der landwirtschaftlichen Arbeitseinheiten (2, 3) zu empfangen und/oder bedienerseitig über eine Eingabeeinrichtung (22) der landwirtschaftlichen Arbeitseinheit (2, 3) eingegebene arbeitssituationsspezifische Informationen (I) zu empfangen.

8. Landwirtschaftliches Arbeitssystem nach einem der vorhergehenden Ansprüche, **dadurch gekennzeichnet, dass** das Mustererkennungssystem (19) eine Kommunikationsschnittstelle (23) zum Empfang der arbeitssituationsspezifischen Informationen (I) und zum Übermitteln der Metainformation (M) und/oder einen Rechner (24) zur Verarbeitung der arbeitssituationsspezifischen Informationen (I) und einen Datenspeicher (25), in dem mindestens ein Situationsmuster (20a, 20b, 20c) hinterlegt ist, aufweist.

9. Landwirtschaftliches Arbeitssystem nach einem der vorhergehenden Ansprüche, **dadurch gekennzeichnet, dass** das Mustererkennungssystem (19) teilweise oder vollständig cloudbasiert ist und/oder maschinenseitig und/oder stationär bereitgestellt wird.

10. Landwirtschaftliches Arbeitssystem nach einem der vorhergehenden Ansprüche, **dadurch gekennzeichnet, dass** die Funktionseinheiten (11, 12) jeweils eine Kommunikationsschnittstelle (27) zum Empfang der Metainformation (M) aufweisen, wobei die Kommunikationsschnittstelle (27) insbesondere konfiguriert ist zur Übertragung von arbeitssituationsspezifischen Informationen (I) und/oder zum Datenaustausch mit einer Kommunikationsschnittstelle (27) einer anderen Funktionseinheit (11, 12).

11. Landwirtschaftliches Arbeitssystem nach einem der vorhergehenden Ansprüche, **dadurch gekennzeichnet, dass** die Steuerungseinrichtungen (13) der Funktionseinheiten (11, 12) jeweils einen Mikrocontroller (28) zur Verarbeitung der jeweiligen Metainformation (M) und einen Datenspeicher (29), in dem das Regelwerk (14) hinterlegt ist, aufweisen.

12. Landwirtschaftliches Arbeitssystem nach einem der vorhergehenden Ansprüche, **dadurch gekennzeichnet, dass** das Regelwerk (14) Parameter, Parametersätze und/oder Parameterfolgen für mindestens ein Arbeitsaggregat der landwirtschaftlichen Arbeitseinheit (2, 3) aufweist, die verschiedenen Arbeitssituationen zugeordnet sind, wobei die jeweilige Steuerungseinrichtung (13) konfiguriert ist, basierend auf der erhaltenen Metainformation (M) mindestens einen Parameter, mindestens einen Parametersatz und/oder mindestens eine Parameterfolge für mindestens ein Arbeitsaggregat der landwirtschaftlichen Arbeitseinheit (2, 3) einzustellen und die mindestens eine Einstellung mit mindestens einer Einstellung einer anderen Funktionseinheit (11, 12), die auf derselben Metainformation (M) basiert, zu koordinieren.

13. Landwirtschaftliches Arbeitssystem nach einem der vorhergehenden Ansprüche, **dadurch gekennzeichnet, dass** die arbeitssituationsspezifischen Informationen (I) Informationen aus einer oder mehreren Situationsebenen (E, E₀, E₁) beinhalten, wobei die arbeitssituationsspezifischen Informationen (I) jeweils mindestens eine Information zu mindestens einer Hauptarbeitssituation, mindestens einer Nebenarbeitssituation, mindestens einer Vortriebsituation, mindestens einer Maschinensituation, mindestens einer Sicherheitssituation, mindestens einem Automatiklevel, mindestens einer Simulationssituation und/oder mindestens einer Beladungssituation beinhalten.

14. Landwirtschaftliches Arbeitssystem nach einem der vorhergehenden Ansprüche, **dadurch gekennzeichnet, dass** der Datenaustausch zwischen dem Mustererkennungssystem (19) und der jeweiligen Funktionseinheit (11,12) und/oder zwischen den Funktionseinheiten (11, 12) in Echtzeit erfolgt.

15. Landwirtschaftliches Arbeitssystem nach einem der vorhergehenden Ansprüche, **dadurch gekennzeichnet, dass** das landwirtschaftliche Arbeitssystem (1) um weitere Funktionseinheiten (11, 12) zur Durchführung oder Unterstützung landwirtschaftlicher Arbeit modular erweiterbar ist, die jeweils eine Steuerungseinrichtung (13) zur Steuerung der jeweiligen Funktionseinheit (11, 12) basierend auf einem hinterlegten Regelwerk (14) aufweisen und derart konfiguriert sind, dass sie eine eine vom Mustererkennungssystem (19) identifizierte Arbeitssituation charakterisierende Metainformation (M) empfangen können und dass die Steuerungseinrichtung (13) der jeweils weiteren Funktionseinheit (11, 12) und eine Steuerungseinrichtung (13) einer anderen Funktionseinheit (11, 12), die in der identifizierten Arbeitssituation mit der jeweiligen weiteren Funktionseinheit (11, 12) zusammenarbeitet, basierend auf der erhaltenen Metainformation (M) ihr Zusammenarbeiten koordinieren und Parametereinstellungen der zugehörigen Funktionseinheit (11, 12) vornehmen.

16. Verfahren zur Optimierung von landwirtschaftlichen Arbeitsabläufen unter Verwendung eines landwirtschaftlichen Arbeitssystems (1), insbesondere eines landwirtschaftlichen Arbeitssystems (1) nach einem der vorhergehenden Ansprüche, mit mindestens einer landwirtschaftlichen Arbeitseinheit (2, 3), insbesondere einer landwirtschaftlichen Arbeitsmaschine und/oder einer stationären landwirtschaftlichen Einrichtung, wobei das landwirtschaftliche Arbeitssystem (1) mehrere Funktionseinheiten (11, 12) zur Durchführung oder Unterstützung landwirtschaftlicher Arbeit aufweist, die jeweils eine Steuerungseinrichtung (13) zur Steuerung der jeweiligen Funktionseinheit (11, 12) basierend auf einem hinterlegten Regelwerk (14) aufweisen,
**dadurch gekennzeichnet,**
**dass** das landwirtschaftliche Arbeitssystem (1) ein zentrales Mustererkennungssystem (19) aufweist, in dem mindestens eine landwirtschaftliche Arbeitssituation als Situationsmuster (20a, 20b, 20c) hinterlegt ist, wobei dem Mustererkennungssystem (19) arbeitssituationsspezifische Informationen (I) übergeben werden, das Mustererkennungssystem (19) basierend auf den erhaltenen arbeitssituationsspezifischen Informationen (I) eine hinterlegte Arbeitssituation und das zugehörige Situationsmuster (20a, 20b, 20c) identifiziert und eine die identifizierte Arbeitssituation charakterisierende Metainformation (M) an die mehreren Funktionseinheiten (11, 12) überträgt, und
**dass** das Mustererkennungssystem (19) und/oder die Steuerungseinrichtungen (13) der mehreren Funktionseinheiten (11, 12) das Zusammenwirken derjenigen Funktionseinheiten (11, 12), die in der identifizierten Arbeitssituation zusammenarbeiten, basierend auf der Metainformation (M) koordiniert/koordinieren, sodass die Steuerungseinrichtungen (13) entsprechende Parametereinstellungen der zugehörigen Funktionseinheit (11, 12) vornehmen.

17. Verfahren nach Anspruch 16, **dadurch gekennzeichnet,**
**dass** der Bediener über eine Eingabeeinrichtung (22) einer als Mähdrescher ausgestalteten ersten Arbeitseinheit (2, 3) als arbeitssituationsspezifische Informationen (I) die Arbeitssituation "Freischneiden" vorgibt,
**dass** die arbeitssituationsspezifischen Informationen (I) an das Mustererkennungssystem (19) übergeben werden,
**dass** das Mustererkennungssystem (19) basierend auf den erhaltenen arbeitssituationsspezifischen Informationen (I) die hinterlegte Arbeitssituation "Freischneiden" und das zugehörige Situationsmuster (20a, 20b, 20c) identifiziert und eine die identifizierte Arbeitssituation "Freischneiden" charakterisierende Metainformation (M) an alle jeweils eine Funktionseinheit (11, 12) bildenden weiteren Arbeitseinheiten (2, 3) des landwirtschaftlichen Arbeitssystems (1) überträgt,
**dass** das Zusammenwirken der in der Arbeitssituation "Freischneiden" zusammenarbeitenden Arbeitseinheiten (2, 3) basierend auf der Metainformation (M) koordiniert wird,
indem bei der als Mähdrescher ausgestalteten ersten Arbeitseinheit (2, 3) für die Arbeitssituation "Freischneiden" spezifisch vorgesehene Parametereinstellungen vorgenommen werden und/oder
indem als weitere Arbeitseinheit (2, 3) für die Arbeitssituation "Freischneiden" ein weiterer Mähdrescher angefordert wird und/oder
indem als weitere Arbeitseinheit (2, 3) für eine der Arbeitssituation "Freischneiden" nachfolgende Arbeitssituation "Überladevorgang" ein Abtankfahrzeug angefordert wird.

18. Verfahren nach Anspruch 16 oder 17, **dadurch gekennzeichnet, dass** dem Mustererkennungssystem (19) einzelne oder mehrere arbeitssituationsspezifische Informationen (I) von einer oder mehreren Arbeitseinheiten (2, 3), von einer oder mehreren Funktionseinheiten (11, 12), von einem oder mehreren Sensoren (21) mindestens einer der Arbeitseinheiten (2, 3), von einer oder mehreren Eingabeeinrichtungen (22) zur bedienerseitigen Eingabe von arbeitssituationsspezifischen Informationen (I) und/oder von einer oder mehreren weiteren Einrichtungen zur Erfassung von arbeitssituationsspezifischen Informationen (I) übergeben werden, vorzugsweise, dass das Mustererkennungssystem (19) die übergebenen arbeitssituationsspezifischen Informationen (I) und/oder eine basierend darauf vom Mustererkennungssystem (19) erzeugte Metainformation (M) an einzelne oder mehrere dieser Einrichtungen, insbesondere alle Einrichtungen, zurücküberträgt.

## Claims

1. An agricultural working system for optimizing agricultural working procedures, having at least one agricultural working unit (2, 3) in particular an agricultural working machine and/or stationary agricultural equipment, wherein the agricultural working system (1) has a plurality of functional units (11, 12) for carrying out or supporting agricultural work, each having a control device (13) for controlling the respective functional unit (11, 12) based on a stored set of rules (14),
**characterized in that**
the agricultural working system (1) has a central pattern recognition system (19) which is configured such that at least one agricultural work situation is stored in the pattern recognition system (19) as a situation pattern (20a, 20b, 20c), to which pattern recognition system (19) work situation-specific information (I) can be transferred, and based on the work situation-specific information (I) obtained, the pattern recognition system (19) identifies a stored work situation and the associated situation pattern (20a, 20b, 20c) and transmits meta-information (M) characterizing the identified work situation to the functional units (11, 12), and
**in that** the pattern recognition system (19) and/or the control devices (13) of the plurality of functional units (11, 12) is/are configured to coordinate the cooperation of those functional units (11, 12) which work together in the identified work situation based on the meta-information (M), so that the control devices (13) carry out corresponding adjustments to the parameters of the associated functional unit (11, 12).

2. The agricultural working system according to claim 1, **characterized in that** the pattern recognition system (19) coordinates the cooperation of those functional units (11, 12) which work together in the identified work situation based on the meta-information (M), and the control devices (13) of these functional units (11, 12) carry out corresponding adjustments to the parameters of the associated functional unit, and/or
**in that** the control devices (13) of those functional units (11, 12) which work together in the identified work situation coordinate the cooperation of these functional units (11, 12) with one another based on the meta-information (M) obtained and carry out adjustments to the parameters of the associated functional unit (11, 12).

3. The agricultural working system according to claim 1 or claim 2, **characterized in that** the meta-information (M) contains data constituting a designation and/or description of the work situation and preferably, the meta-information (M) exclusively contains data constituting a designation and/or description of the work situation, or **in that** in addition to data constituting a designation and/or description of the work situation, the meta-information (M) also contains parameters, parameter sets or parameter sequences for controlling the respective functional unit (11, 12) and/or references to parameters, parameter sets or parameter sequences stored in the respective functional unit (11, 12) for controlling the respective functional unit (11, 12).

4. The agricultural working system according to one of the preceding claims, **characterized in that** the meta-information (M) contains data which constitute a designation and/or description of the "brush cutting" work situation, the "harvesting along a wheel track in the field" work situation, the "approaching a headland" work situation, the "headland" work situation, the "approaching an obstacle" work situation, the "accompanied travel" work situation, the "load transferring process" work situation, the "grain collection" work situation, the "straw baling" work situation and/or the "straw bale collection" work situation.

5. The agricultural working system according to one of the preceding claims, **characterized in that** the plurality of functional units (11, 12) are formed by different agricultural working units (2, 3), preferably **in that** at least one of the functional units (11, 12) is an agricultural working machine and/or **in that** at least one of the functional units (11, 12) is an attachment which is coupled to or can be coupled to an agricultural working machine, and/or at least one of the functional units (11, 12) is stationary agricultural equipment.

6. The agricultural working system according to one of the preceding claims, **characterized in that** the plurality of functional units (11, 12) is formed by different working assemblies of an agricultural working unit (2, 3), and preferably, one of the functional units (11, 12) is a propulsion unit (15) of the agricultural working machine and/or **in that** a functional unit (11, 12) is a steering system (16) of the agricultural working machine and/or **in that** a functional unit (11, 12) is a driver assistance system for the agricultural working machine and/or **in that** a functional unit (11, 12) is a harvested crop-processing working assembly of the agricultural working machine or of the stationary agricultural equipment and/or **in that** a functional unit (11, 12) is a crop-processing working assembly of the mounted implement.

7. The agricultural working system according to one of the preceding claims, **characterized in that** the pattern recognition system (19) is configured to receive one or more items of work situation-specific information (I) from sensors (21) of the at least one agricultural working unit (2, 3) or a plurality of the agricultural working units (2, 3), and/or to receive work situation-specific information (I) entered by an operator via an input device (22) of the agricultural working unit (2, 3).

8. The agricultural working system according to one of the preceding claims, **characterized in that** the pattern recognition system (19) has a communications interface (23) for receiving the work situation-specific information (I) and for transmitting the meta-information (M) and/or a computer (24) for processing the work situation-specific information (I) and a data storage unit (25) in which at least one situation pattern (20a, 20b, 20c) is stored.

9. The agricultural working system according to one of the preceding claims, **characterized in that** the pattern recognition system (19) is partially or completely cloud-based and/or provided in a machine and/or in a stationary manner.

10. The agricultural working system according to one of the preceding claims, **characterized in that** the functional units (11, 12) each have a communications interface (27) for receiving the meta-information (M), wherein in particular, the communications interface (27) is configured to transmit work situation-specific information (I) and/or to exchange data with a communications interface (27) of another functional unit (11, 12).

11. The agricultural working system according to one of the preceding claims, **characterized in that** the control devices (13) of the functional units (11, 12) each have a microcontroller (28) for processing the respective meta-information (M) and a data storage unit (29) in which the set of rules (14) is stored.

12. The agricultural working system according to one of the preceding claims, **characterized in that** the set of rules (14) has parameters, parameter sets and/or parameter sequences for at least one working assembly of the agricultural working unit (2, 3) which are associated with different work situations, wherein the respective control device (13) is configured to adjust at least one parameter, at least one parameter set and/or at least one parameter sequence for at least one working assembly of the agricultural working unit (2, 3) based on the meta-information (M) obtained and to coordinate the at least one adjustment with at least one adjustment of another functional unit (11, 12) based on the same meta-information (M).

13. The agricultural working system according to one of the preceding claims, **characterized in that** the work situation-specific information (I) contains information from one or more situation levels (E, E₀, E₁), wherein the work situation-specific information (I) respectively contains at least one item of information relating to at least one main work situation, at least one auxiliary work situation, at least one propulsion situation, at least one machine situation, at least one safety situation, at least one automatic level, at least one simulation situation and/or at least one load situation.

14. The agricultural working system according to one of the preceding claims, **characterized in that** the exchange of data between the pattern recognition system (19) and the respective functional unit (11, 12) and/or between the functional units (11, 12) is carried out in real time.

15. The agricultural working system according to one of the preceding claims, **characterized in that** the agricultural working system (1) can be expanded in a modular manner by means of further functional units (11, 12) for carrying out or supporting agricultural work, each having a control device (13) for controlling the respective functional unit (11, 12) based on a stored set of rules (14) and being configured such that they can receive meta-information (M) characterizing a work situation identified by the pattern recognition system (19) and **in that** the control device (13) of the respective further functional unit (11, 12) and a control device (13) of another functional unit (11, 12) which works together with the respective further functional unit (11, 12) in the identified work situation coordinate their cooperation based on the meta-information (M) obtained and carry out adjustments to the parameters of the associated functional unit (11, 12).

16. A method for optimizing agricultural working procedures using an agricultural working system (1), in particular an agricultural working system (1) according to one of the preceding claims, having least one agricultural working unit (2, 3), in particular an agricultural working machine and/or stationary agricultural equipment, wherein the agricultural working system (1) has a plurality of functional units (11, 12) for carrying out or supporting agricultural work, which each have a control device (13) for controlling the respective functional unit (11, 12) based on a stored set of rules (14),
**characterized in that**
the agricultural working system (1) has a central pattern recognition system (19) in which at least one agricultural work situation is stored as a situation pattern (20a, 20b, 20c), wherein work situation-specific information (I) is transferred to the pattern recognition system (19), and based on the work situation-specific information (I) obtained, the pattern recognition system (19) identifies a stored work situation and the associated situation pattern (20a, 20b, 20c) and transmits meta-information (M) characterizing the identified work situation to the functional units (11, 12), and
**in that** the pattern recognition system (19) and/or the control devices (13) of the plurality of functional units (11, 12) coordinate the cooperation of those functional units (11, 12) which work together in the identified work situation based on the meta-information (M), so that the control devices (13) carry out corresponding adjustments to the parameters of the associated functional unit (11, 12).

17. The method according to claim 16, **characterized in that** the operator specifies the "brush cutting" work situation as the work situation-specific information (I) via an input device (22) of a first working unit (2, 3) configured as a combine harvester,
**in that** the work situation-specific information (I) is transferred to the pattern recognition system (19),
**in that** the pattern recognition system (19) identifies the stored "brush cutting" work situation and the associated situation pattern (20a, 20b, 20c) based on the work situation-specific information (I) obtained and transmits meta-information (M) characterizing the identified "brush cutting" work situation to all of the further working units (2, 3) of the agricultural working system (1) which each form a functional unit (11, 12),
**in that** the cooperation of the working units (2, 3) working together in the "brush cutting" work situation is coordinated based on the meta-information (M),
**in that** parameter adjustments specifically provided for the "brush cutting" work situation are carried out in the first working unit (2, 3) configured as a combine harvester, and/or
**in that** a further combine harvester is requested as a further working unit (2, 3) for the "brush cutting" work situation, and/or in that an unloading vehicle is requested as a further working unit (2, 3) for a "load transferring process" work situation following the "brush cutting" work situation.

18. The method according to claim 16 or claim 17, **characterized in that** one or more items of work situation-specific information (I) is/are transferred to the pattern recognition system (19) from one or more working units (2, 3), from one or more functional units (11, 12), from one or more sensors (21) of at least one of the working units (2, 3), from one or more input devices (22) for operator input of work situation-specific information (I), and/or from one or more further devices for acquiring work situation-specific information (I), and preferably **in that** the pattern recognition system (19) transmits the transferred work situation-specific information (I) and/or generated meta-information (M) based thereon from the pattern recognition system (19) back to one or more of said devices, in particular to all of the devices.

## Revendications

1. Système de travail agricole pour l'optimisation de séquences de travail agricole, comprenant au moins une unité de travail agricole (2, 3), en particulier d'une machine de travail agricole et/ou d'un équipement agricole fixe, le système de travail agricole (1) comportant plusieurs unités fonctionnelles (11, 12) pour réaliser ou assister le travail agricole, lesquelles comportent respectivement un équipement de commande (13) pour commander l'unité fonctionnelle (11, 12) sur la base d'une base de règles enregistrée (14), **caractérisé en ce que** le système de travail agricole (1) comporte un système central de reconnaissance de modèles (19) qui est configuré de façon qu'au moins une situation de travail agricole soit enregistrée comme modèle de situation (20a, 20b, 20c), que des informations (I) spécifiques à une situation de travail sont transmissibles au système de reconnaissance de modèles (19), que, sur la base des informations reçues (I) spécifiques à une situation de travail, le système de reconnaissance de modèles (19) identifie une situation de travail enregistrée et le modèle de situation associé (20a, 20b, 20c) et transmet aux unités fonctionnelles (11, 12) une méta-information (M) caractérisant la situation de travail identifiée, et **en ce que** le système de reconnaissance de modèles (19) et/ou les équipements de commande (13) des plusieurs unités fonctionnelles (11, 12) est/sont configurés pour coordonner, sur la base de la méta-information (M), la coopération des unités fonctionnelles (11, 12) qui collaborent dans la situation de travail identifiée, de façon que les équipements de commande (13) effectuent des réglages paramétriques correspondants de l'unité fonctionnelle associée (11, 12).

2. Système de travail agricole selon la revendication 1, **caractérisé en ce que** le système de reconnaissance de modèles (19) coordonne, sur la base de la méta-information (M), la coopération des unités fonctionnelles (11, 12) qui collaborent dans la situation de travail identifiée, et les équipements de commande (13) de ces unités fonctionnelles (11, 12) effectuent des réglages paramétriques correspondants de l'unité fonctionnelle associée (11, 12), et/ou **en ce que** les équipements de commande (13) des unités fonctionnelles (11, 12), qui coopèrent dans la situation de travail identifiée, coordonnent, sur la base de la méta-information reçue (M), la coopération de ces unités fonctionnelles (11, 12) entre elles et effectuent des réglages paramétriques de l'unité fonctionnelle associée (11, 12).

3. Système de travail agricole selon la revendication 1 ou 2, **caractérisé en ce que** la méta-information (M) contient des données représentant une désignation et/ou description de la situation de travail, de préférence **en ce que** la méta-information (M) convient exclusivement des données représentant une désignation et/ou description de la situation de travail, ou **en ce que** la méta-information (M) contient, en plus des données représentant une désignation et/ou description de la situation de travail, également des paramètres, des jeux de paramètres ou des suites de paramètres pour commander l'unité fonctionnelle respective (11, 12) et/ou des renvois à des paramètres, des jeux de paramètres ou des suites de paramètres enregistrés dans l'unité fonctionnelle respective (11, 12) pour commander l'unité fonctionnelle respective (11, 12) .

4. Système de travail agricole selon une des revendications précédentes, **caractérisé en ce que** la méta-information (M) contient des données qui représentent une désignation et/ou description de la situation de travail « fauche tournière », de la situation de travail « récolte suivant une trace de roulement dans le champ », de la situation de travail « approche d'une tournière », de la situation de travail « tournière », de la situation de travail « approche d'un obstacle », de la situation de travail « parcours d'accompagnement », de la situation de travail « opération de transfert », de la situation de travail « ramassage de céréale », de la situation de travail « confection de balles de paille » et/ou de la situation de travail « ramassage de balles de paille ».

5. Système de travail agricole selon une des revendications précédentes, **caractérisé en ce que** les plusieurs unités fonctionnelles (11, 12) sont formées par différentes unités de travail agricole (2, 3), de préférence **en ce qu'**au moins une unité fonctionnelle (11, 12) est une machine de travail agricole et/ou **en ce qu'**au moins une unité fonctionnelle (11, 12) est un outil rapporté couplé ou couplable à une machine de travail agricole et/ou au moins une unité fonctionnelle (11, 12) est un équipement agricole fixe.

6. Système de travail agricole selon une des revendications précédentes, **caractérisé en ce que** les plusieurs unités fonctionnelles (11, 12) sont formées par différents organes de travail d'une unité de travail agricole (2, 3), de préférence **en ce qu'**une unité fonctionnelle (11, 12) est un groupe propulseur (15) de la machine de travail agricole et/ou **en ce qu'**une unité fonctionnelle (11, 12) est un système directionnel (16) de la machine de travail agricole et/ou **en ce qu'**une unité fonctionnelle (11, 12) est un système d'assistance à la conduite de la machine de travail agricole et/ou **en ce qu'**une unité fonctionnelle (11, 12) est un organe de travail traitant du produit récolté de la machine de travail agricole ou de l'équipement agricole fixe et/ou **en ce qu'**une unité fonctionnelle (11, 12) est un organe de travail traitant du produit récolté de l'outil rapporté.

7. Système de travail agricole selon une des revendications précédentes, **caractérisé en ce que** le système de reconnaissance de modèles (19) est configuré pour recevoir des informations individuelles ou multiples (I) spécifiques à une situation de travail depuis des capteurs (21) de la au moins une unité de travail agricole (2, 3) ou de plusieurs des unités de travail agricole (2, 3) et/ou pour recevoir des informations (I) spécifiques à une situation de travail entrées côté utilisateur par l'intermédiaire d'un équipement d'entrée (22) de l'unité de travail agricole (2, 3).

8. Système de travail agricole selon une des revendications précédentes, **caractérisé en ce que** le système de reconnaissance de modèles (19) comporte une interface de communication (23) pour recevoir les informations (I) spécifiques à une situation de travail et pour transmettre la méta-information (M), et/ou un ordinateur (24) pour traiter les informations (I) spécifiques à une situation de travail et une mémoire de données (25) dans laquelle au moins un modèle de situation (20a, 20b, 20c) est enregistré.

9. Système de travail agricole selon une des revendications précédentes, **caractérisé en ce que** le système de reconnaissance de modèles (19) est partiellement ou entièrement basé sur le cloud et/ou est mis à disposition côté machine et/ou en poste fixe.

10. Système de travail agricole selon une des revendications précédentes, **caractérisé en ce que** les unités fonctionnelles (11, 12) comportent respectivement une interface de communication (27) pour recevoir la méta-information (M), l'interface de communication (27) étant en particulier configurée pour la transmission d'informations (I) spécifiques à une situation de travail et/ou pour l'échange de données avec une interface de communication (27) d'une autre unité fonctionnelle (11, 12).

11. Système de travail agricole selon une des revendications précédentes, **caractérisé en ce que** les équipements de commande (13) des unités fonctionnelles (11, 12) comportent respectivement un microcontrôleur (28) pour traiter la méta-information respective (M) et une mémoire de données (29) dans laquelle la base de règles (14) est enregistrée.

12. Système de travail agricole selon une des revendications précédentes, **caractérisé en ce que** la base de règles (14) comporte des paramètres, des jeux de paramètres et/ou des suites de paramètres pour au moins un organe de travail de l'unité de travail agricole (2, 3), lesquels sont affectés à différentes situations de travail, l'équipement de commande respectif (13) étant configuré pour régler, sur la base de la méta-information (M) reçue, au moins un paramètre, au moins un jeu de paramètres et/ou au moins une suite de paramètres pour au moins un organe de travail de l'unité de travail agricole (2, 3) et pour coordonner le au moins un réglage avec un réglage d'une autre unité fonctionnelle (11, 12) qui est basée sur la même méta-information (M).

13. Système de travail agricole selon une des revendications précédentes, **caractérisé en ce que** les informations (I) spécifiques à une situation de travail contiennent des informations provenant d'un ou plusieurs plans de situations (E, E₀, E₁), les informations (I) spécifiques à une situation de travail contenant respectivement au moins une information sur au moins une situation de travail principale, sur au moins une situation de travail secondaire, sur au moins une situation de propulsion, sur au moins une situation de machine, sur au moins une situation de sécurité, sur au moins un niveau automatique, sur au moins une situation de simulation et/ou sur au moins une situation de chargement.

14. Système de travail agricole selon une des revendications précédentes, **caractérisé en ce que** l'échange de données entre le système de reconnaissance de modèles (19) et l'unité fonctionnelle respective (11, 12) et/ou entre les unités fonctionnelles (11, 12) s'effectue en temps réel.

15. Système de travail agricole selon une des revendications précédentes, **caractérisé en ce que** le système de travail agricole (1) peut être élargi modulairement à d'autres unités fonctionnelles (11, 12) pour réaliser ou assister le travail agricole, lesquelles comportent respectivement un équipement de commande (13) pour commander l'unité fonctionnelle respective (11, 12) sur la base d'une base de règles enregistrée (14) et sont configurées de façon à pouvoir recevoir une méta-information (M) caractérisant une situation de travail identifiée par le système de reconnaissance de modèles (19), et **en ce que** l'équipement de commande (13) de l'autre unité fonctionnelle respective (11, 12) et un équipement de commande (13) d'une autre unité fonctionnelle (11, 12) qui coopère avec l'autre unité fonctionnelle respective (11, 12) dans la situation de travail identifiée coordonnent leur coopération sur la base de la méta-information reçue (M) et effectuent des réglages paramétriques de l'unité fonctionnelle associée (11, 12).

16. Procédé d'optimisation de séquences de travail agricole en utilisant un système de travail agricole (1), en particulier un système de travail agricole (1) selon une des revendications précédentes, comprenant au moins une unité de travail agricole (2, 3), en particulier d'une machine de travail agricole et/ou d'un équipement agricole fixe, le système de travail agricole (1) comportant plusieurs unités fonctionnelles (11, 12) pour réaliser ou assister le travail agricole, lesquelles comportent respectivement un équipement de commande (13) pour commander l'unité fonctionnelle respective (11, 12) sur la base d'une base de règles enregistrée (14), **caractérisé en ce que** le système de travail agricole (1) comporte un système central de reconnaissance de modèles (19) dans lequel au moins une situation de travail agricole est enregistrée comme modèle de situation (20a, 20b, 20c), des informations (I) spécifiques à une situation de travail étant transmises au système de reconnaissance de modèles (19), le système de reconnaissance de modèles (19) identifiant sur la base des informations reçues (I) spécifiques à une situation de travail une situation de travail enregistrée et le modèle de situation associé (20a, 20b, 20c), et transmettant aux plusieurs unités fonctionnelles (11, 12) une méta-information (M) caractérisant la situation de travail identifiée, et **en ce que** le système de reconnaissance de modèles (19) et/ou les équipements de commande (13) des plusieurs unités fonctionnelles (11, 12) coordonne/coordonnent, sur la base de la méta-information (M), la coopération des unités fonctionnelles respectives (11, 12) qui collaborent dans la situation de travail identifiée, de façon que les équipements de commande (13) effectuent des réglages paramétriques correspondants de l'unité fonctionnelle associée (11, 12).

17. Procédé selon la revendication 16, **caractérisé en ce que**, par l'intermédiaire d'un équipement d'entrée (22) d'une première unité de travail (2, 3) conformée en moissonneuse-batteuse, l'utilisateur prescrit comme informations (I) spécifiques à une situation de travail la situation de travail « faucher tournière », **en ce que** les informations (I) spécifiques à une situation de travail sont transmises au système de reconnaissance de modèles (19), **en ce que**, sur la base des informations reçues (I) spécifiques à une situation de travail, le système de reconnaissance de modèles (19) identifie la situation de travail enregistrée « faucher tournière » et le modèle de situation associé (20a, 20b, 20c) et transmet une méta-information (M) caractérisant la situation de travail identifiée « faucher tournière » à toutes les autres unités de travail (2, 3) du système de travail agricole (1) qui forment respectivement une unité fonctionnelle (11, 12), **en ce que** la coopération des unités de travail (2, 3) collaborant dans la situation de travail « faucher tournière » est coordonnée sur la base de la méta-information (M) par le fait que dans le cas de la première unité de travail (2, 3) conformée en moissonneuse-batteuse sont effectués des réglages paramétriques prévus spécifiquement pour la situation de travail « faucher tournière » et par le fait que comme autre unité de travail (2, 3) pour la situation de travail « faucher turnière » est demandée une autre moissonneuse-batteuse, et/ou par le fait que comme autre unité de travail (2, 3) pour une situation de travail « opération de transfert » succédant à la situation de travail « faucher tournière » est demandé un véhicule de vidage.

18. Procédé selon la revendication 16 ou 17, **caractérisé en ce qu'**au système de reconnaissance de modèles (19) sont transmises des informations individuelles ou multiples (I) spécifiques à une situation de travail par une ou plusieurs unités de travail (2, 3), par une ou plusieurs unités fonctionnelles (11, 12), par un ou plusieurs capteurs (21) au moins d'une des unités de travail (2, 3), par un ou plusieurs équipements d'entrée (22) pour l'entrée, côté utilisateur, d'informations (I) spécifiques à une situation de travail et/ou par un ou plusieurs autres équipements pour détecter des informations (I) spécifiques à une situation de travail, de préférence **en ce que** le système de reconnaissance de modèles (19) transmet en retour les informations transmises (I) spécifiques à une situation de travail et/ou une méta-information (M) générée sur cette base par le système de reconnaissance de modèles (19) à certains ou plusieurs de ces équipements, en particulier à tous les équipements.
